(19) Europäisches Patentamt
European Patent Office
Office européen des brevets

(11) **EP 4 328 602 A1**

(12) **EUROPEAN PATENT APPLICATION**
published in accordance with Art. 153(4) EPC

(43) Date of publication:
**28.02.2024 Bulletin 2024/09**

(51) International Patent Classification (IPC):
**G01R 31/42** (2006.01)   **G01R 31/55** (2020.01)
**G01R 29/16** (2006.01)

(21) Application number: **22810364.4**

(52) Cooperative Patent Classification (CPC):
**G01R 29/16; G01R 31/42; G01R 31/55**

(22) Date of filing: **11.05.2022**

(86) International application number:
**PCT/CN2022/092193**

(87) International publication number:
**WO 2022/247637 (01.12.2022 Gazette 2022/48)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: 26.05.2021 CN 202110579638
30.03.2022 CN 202210332963

(71) Applicants:
• **Foshan Shunde Midea Electric Science and Technology Co., Ltd.**
**Foshan, Guangdong 528300 (CN)**
• **GD Midea Air-Conditioning Equipment Co., Ltd.**
**Foshan, Guangdong 528311 (CN)**
• **Midea Group Co., Ltd.**
**Foshan, Guangdong 528311 (CN)**

(72) Inventors:
• **HUANG, Zhaobin**
**Foshan, Guangdong 528300 (CN)**
• **ZHANG, Jienan**
**Foshan, Guangdong 528300 (CN)**
• **HUANG, Zhenghui**
**Foshan, Guangdong 528300 (CN)**
• **LONG, Tan**
**Foshan, Guangdong 528300 (CN)**
• **WEI, Dong**
**Foshan, Guangdong 528300 (CN)**
• **XU, Jinqing**
**Foshan, Guangdong 528300 (CN)**
• **WEN, Xianshi**
**Foshan, Guangdong 528300 (CN)**
• **ZHAO, Ming**
**Foshan, Guangdong 528300 (CN)**

(74) Representative: **Whitlock, Holly Elizabeth Ann et al**
**Maucher Jenkins**
**Seventh Floor Offices**
**Artillery House**
**11-19 Artillery Row**
**London SW1P 1RT (GB)**

(54) **FAULT DETECTION METHOD AND APPARATUS, AND DEVICE, SYSTEM AND STORAGE MEDIUM**

(57)    A control method, a fault detection apparatus, a device, a system and a storage medium. The method comprises: determining a first target power source line, a second target power source line and a third target power er source line in a three-phase power supply device (101), wherein the three-phase power supply device is used for supplying power to an electric device of a user; measuring a first target voltage between the first target power source line and the second target power source line, and a second target voltage between the first target power source line and the third target power source line (102); determining a fault detection result on the basis of the first target voltage and the second target voltage (103), wherein the fault detection result is used for indicating whether the three-phase power supply device has a wiring error; and if the fault detection result indicates that the three-phase power supply device has a wiring error, generating first prompt information (104), wherein the first prompt information is used for giving a prompt regarding the fact that the three-phase power supply device has a wiring error.

EP 4 328 602 A1

determining a first target power line, a second target power line and a third target power line in a three-phase power supply device — 101

detecting a first target voltage between the first target power line and the second target power line, and a second target voltage between the first target power line and the third target power line — 102

determining a fault detection result based on the first target voltage and the second target voltage — 103

in response to the fault detection result indicating that the wiring error occurs in the three-phase power supply device, generating first prompt information — 104

FIG. 1

**Description**

**CROSS-REFERENCE TO RELATED-APPLICATIONS**

The present application claims priority to Chinese Patent Application No. 202110579638.5, filed on May 26, 2021, and Chinese Patent Application No. 202210332963.6, filed on March 30, 2022, the entire contents of which are incorporated herein by reference.

**TECHNICAL FIELD**

The present application relates to the technical field of power supply detection, in particular to a fault detection method, a fault detection apparatus, a fault detection device, a system and a storage medium.

**BACKGROUND**

In three-phase power supply application systems such as variable frequency air conditioning systems, the adopted three-phase power supply circuits usually include three-phase passive power factor correction (PFC) solution circuits, three-phase active PFC two-level solution circuits and three-phase active PFC three-level solution circuit topology. Among them, the main circuit of the three-phase power supply circuit can be configured to drive the inverter compressor, and one phase can also be derived from the three-phase power supply circuit to independently rectify and supply power to the auxiliary power supply. In addition, the main circuit can further supply power to the direct current (DC) fan drive circuit. At present, in a three-phase power supply circuit, the effective value of the three-phase line voltage is nominally 380V, and the corresponding high-voltage DC bus voltage after the line voltage rectification is 537V. However, in actual application scenarios, a 10% power supply voltage fluctuation tolerance error is usually allowed. In this way, the high-voltage DC bus voltage may reach a maximum of 590V.

The withstand voltage that drives the intelligent power module (IPM) of the DC fan is usually 500V or 600V. However, since the IPM is usually designed with derating requirements of the withstand voltage, the input voltage of the DC fan IPM is usually required to be less than 450V. In this way, if the neutral wire and the live wire in the three-phase four-wire power supply are incorrectly connected, the power supply of the auxiliary power supply and the DC fan may be connected to the line voltage. Since the DC voltage after the line voltage rectification is 1.732 times of the rectified phase voltage, the high voltage provided for a long time will cause overvoltage damage to the auxiliary power supply and DC fan drive, and if the neutral wire and live wire are incorrectly connected, the passive PFC or active PFC circuit will not work properly, causing the poor working efficiency in the three-phase four-wire power supply device due to wiring errors.

**SUMMARY**

In order to solve above technical problems, embodiments of the present application aim to provide a fault detection method, an apparatus, a device, a system and a storage medium, which solve the problem of the poor working efficiency caused by the wiring errors of the current three-phase four-wire power supply device (referred to as three-phase power supply device), and realizes a method of effectively detecting wiring errors in advance, effectively ensuring the working efficiency of three-phase four-wire power supply device and improving the intelligence of three-phase four-wire power supply device.

The technical solution of the present application is implemented as follows.

In a first aspect, a fault detection method includes:

determining a first target power line, a second target power line and a third target power line in a three-phase power supply device; wherein the three-phase power supply device is configured to provide power for a user electrical device;

detecting a first target voltage between the first target power line and the second target power line, and a second target voltage between the first target power line and the third target power line;

determining a fault detection result based on the first target voltage and the second target voltage; wherein the fault detection result is configured to indicate whether a wiring error occurs in the three-phase power supply device; and

in response to the fault detection result indicating that the wiring error occurs in the three-phase power supply device, generating first prompt information; wherein the first prompt information is configured to indicate the wiring error in the three-phase power supply device.

In a second aspect, a fault detection apparatus includes a first determination unit; a detection unit; a second determination unit; and a generation unit.

The first determination unit is configured to determine a first target power line, a second target power line and a third target power line in a three-phase power supply device; wherein the three-phase power supply device is configured to power the user electrical device.

The detection unit is configured to detect a first target voltage between the first target power line and the second target power line, and a second target voltage between the first target power line and the third target power line.

The second determination unit is configured to determine a fault detection result based on the first target voltage and the second target voltage; wherein the fault detection result is configured to indicate whether a wiring error occurs in the three-phase power supply device.

The generation unit is configured to generate first prompt information in response to the fault detection result indicating that the wiring error occurs in the three-phase power supply device; wherein the first prompt information is configured to indicate that the wiring error occurs in the three-phase power supply device.

In a third aspect, a fault detection device includes a detection circuit and a processor.

The detection circuit is configured to be connected to a first target power line, a second target power line and a third target power line in a three-phase power supply device to detect a first target voltage between the first target power line and the second target power line, and a second target voltage between the first target power line and the third target power line, and to send the first target voltage and the second target voltage to the processor; wherein the three-phase power supply device is configured to supply power to user electrical device;

The processor is configured to receive the first target voltage and the second target voltage sent by the detection circuit, and determine a fault detection result based on the first target voltage and the second target voltage. The fault detection result is configured to indicate whether a wiring error occurs in the three-phase power supply device; wherein in response to the fault detection result indicating that the wiring error occurs in the three-phase power supply device, first prompt information is generated. The first prompt information is configured to indicate that the wiring error occurs in the three-phase power supply device.

In a fourth aspect, a three-phase power supply system includes a three-phase power supply device configured to provide three-phase power and any one of the above-mentioned fault detection devices.

In a fifth aspect, a storage medium is stored with a fault detection program, wherein when the fault detection program is executed by a processor, steps according to any one of the above-mentioned fault detection methods is realized.

In the embodiment of the present application, after determining the first target power line, the second target power line and the third target power line in the three-phase power supply device, the first target voltage between the first target power line and the second target power line, and the second target voltage between the first target power line and the third target power line are detected, and the fault detection result based on the first target voltage and the second target voltage is determined. In response to that the fault detection result indicates that the wiring error occurs in the three-phase power supply device, the first prompt information is generated. In this way, by analyzing the first target voltage between the first target power line and the second target power line, and the second target voltage between the first target power line and the third target power line, it can be determined whether the wiring error occurs in the three-phase power supply device. Therefore, the present application solves the problem of the poor working efficiency caused by the wiring errors of the current three-phase four-wire power supply device, and realizes the method of effectively detecting wiring errors in advance, thereby effectively ensuring the working efficiency of three-phase four-wire power supply device and improving the intelligence of three-phase four-wire power supply device.

**BRIEF DESCRIPTION OF THE DRAWINGS**

FIG. 1 is a schematic flowchart 1 of a fault detection method provided by an embodiment of the present application.
FIG. 2 is a schematic flowchart 2 of the fault detection method provided by the embodiment of the present application.
FIG. 3 is a schematic flowchart 3 of the fault detection method provided by the embodiment of the present application.
FIG. 4 is a schematic flowchart 4 of the fault detection method provided by the embodiment of the present application.
FIG. 5a is a circuit topology diagram of a three-phase passive PFC device provided by an embodiment of the present application.
FIG. 5b is a circuit topology diagram of a three-phase active PFC two-level device provided by the embodiment of the present application.
FIG. 5c is a circuit topology diagram of a three-phase active PFC three-level device provided by the embodiment of the present application.

FIG. 6 is a schematic diagram of a connection between a three-phase power supply device and a voltage detection apparatus provided by the embodiment of the present application.

FIG. 7 is a schematic diagram of another connection between the three-phase power supply device and a voltage detection apparatus provided by the embodiment of the present application.

FIG. 8a is a schematic diagram of a circuit connection for detecting two line voltages provided by the embodiment of the present application.

FIG. 8b is a schematic diagram of a circuit connection for detecting two phase voltages provided by the embodiment of the present application.

FIG. 9 is a schematic diagram of a three-phase voltage vector provided by an embodiment of the present application.

FIG. 10a is a schematic diagram of $V_{CN}$ operation after a live wire A and a neutral wire N are reversely connected according to the embodiment of the present application.

FIG. 10b is a schematic diagram of $V_{CN}$ operation after a live wire B and the neutral wire N are reversely connected according to the embodiment of the present application.

FIG. 10c is a schematic diagram of $V_{CN}$ operation after a live wire C and the neutral wire N are reversely connected according to the embodiment of the present application.

FIG. 11a is a schematic circuit connection diagram of a voltage detection apparatus including three voltage detection circuits provided by the embodiment of the present application.

FIG. 11b is a schematic circuit connection diagram of another voltage detection apparatus including three voltage detection circuits provided by the embodiment of the present application.

FIG. 12 is a schematic flowchart 5 of the fault detection method provided by the embodiment of the present application.

FIG. 13 is a circuit topology diagram of the three-phase power supply device provided by the embodiment of the present application.

FIG. 14 is a schematic diagram of a connection between the three-phase power supply device and a fault detection device provided by the embodiment of the present application.

FIG. 15a is a schematic diagram of the voltage vector after the live wire A and the neutral wire N are reversely connected according to the embodiment of the present application.

FIG. 15b is a schematic diagram of the voltage vector after the live wire B and the neutral wire N are reversely connected according to the embodiment of the present application.

FIG. 16 is a schematic flowchart 6 of the fault detection method provided by the embodiment of the present application.

FIG. 17 is a schematic flowchart 7 of the fault detection method provided by the embodiment of the present application.

FIG. 18 is a schematic diagram of a circuit connection for detecting the line voltage and the phase voltage provided by the embodiment of the present application.

FIG. 19a is another schematic diagram of $V_{CN}$ operation after the live wire A and the neutral wire N are reversely connected according to the embodiment of the present application.

FIG. 19b is another schematic diagram of $V_{CN}$ operation after the live wire B and the neutral wire N are reversely connected according to the embodiment of the present application.

FIG. 19c is another schematic diagram of $V_{CN}$ operation after the live wire C and the neutral wire N are reversely connected according to the embodiment of the present application.

FIG. 20 is a schematic circuit connection diagram of a voltage detection circuit provided by the embodiment of the present application.

FIG. 21 is a schematic structural diagram of a fault detection apparatus provided by an embodiment of the present application.

FIG. 22 is a schematic structural diagram of the fault detection device provided by an embodiment of the present application.

FIG. 23 is a schematic structural diagram of a three-phase power supply system provided by the embodiment of the present application.

## DETAILED DESCRIPTION OF THE EMBODIMENTS

In order to make the purpose, technical solutions and advantages of the present application clearer, the present application will be described in further detail below in conjunction with the accompanying drawings. The described embodiments should not be regarded as limiting the present application. All other embodiments obtained by those of ordinary skill in the art without creative efforts fall within the scope of the present application.

Unless otherwise defined, all technical and scientific terms used herein have the same meaning as commonly understood by one of ordinary skill in the technical field to which the present application belongs. The terms used herein are only for the purpose of describing the embodiments of the present application and are not intended to limit the present application.

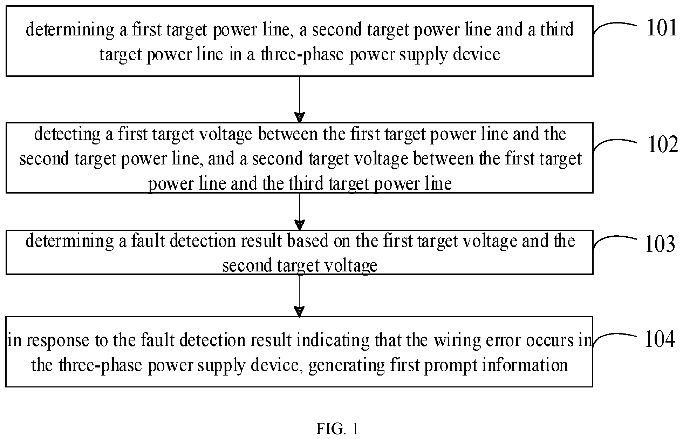

The embodiment of the present application provides a fault detection method. As shown in FIG. 1, the method is applied to fault detection device. The method includes the following steps:

Step 101: determining a first target power line, a second target power line and a third target power line in a three-phase power supply device.

The three-phase power supply device is configured to provide power for user electrical device.

In the embodiments of the present application, the three-phase power supply device may be a three-phase four-wire power supply device configured to provide three-phase power. That is, the three-phase power supply device includes three live wires and one neutral wire. The three live wires and one neutral wire include a first target power line, a second target power line and a third target power line.

Step 102: detecting a first target voltage between the first target power line and the second target power line, and a second target voltage between the first target power line and the third target power line.

In the embodiment of the present application, the voltage detection apparatus can be configured to detect the first target voltage between the first target power line and the second target power line, and the second target voltage between the first target power line and the third target power line.

Step 103: determining a fault detection result based on the first target voltage and the second target voltage.

The fault detection result is configured to indicate whether a wiring error occurs in the three-phase power supply device.

In the embodiment of the present application, the first target voltage and the second target voltage are analyzed to determine whether the neutral wire is incorrectly connected when the three-phase power supply device supplies power to the user electrical device.

Step 104: in response to the fault detection result indicating that the wiring error occurs in the three-phase power supply device, generating first prompt information.

The first prompt information is configured to indicate the wiring error in the three-phase power supply device.

In the embodiment of the present application, in response to that the fault detection result indicates that there is no wiring error in the three-phase power supply device, the three-phase power supply device is controlled to normally provide working power to the user electrical device. In response to that the fault detection result indicates that a wiring error occurs in the three-phase power supply device, the three-phase power supply device is controlled to temporarily not provide working power to the user electrical device, and a first information indicating a wiring error in the three-phase power supply device is generated. The first prompt information can be displayed in a display area corresponding to the fault detection device, or the generated first prompt information can be sent to a display device that has a communication link with the fault detection device. For example, it can be a computer device or a smart mobile terminal device of a manager who monitors the three-phase power supply device, such as mobile phones, etc., in this way, alarms for wiring errors in three-phase power supply device can be realized, which ensures the quality and safety of user electrical device.

In the embodiment of the present application, after determining the first target power line, the second target power line and the third target power line in the three-phase power supply device, the first target voltage between the first target power line and the second target power line, and the second target voltage between the first target power line and the third target power line are detected, and the fault detection result based on the first target voltage and the second target voltage is determined. In response to that the fault detection result indicates that the wiring error occurs in the three-phase power supply device, the first prompt information is generated. In this way, by analyzing the first target voltage between the first target power line and the second target power line, and the second target voltage between the first target power line and the third target power line, it can be determined that whether the wiring error occurs in the three-phase power supply device. Therefore, the present application solves the problem of the poor working efficiency caused by the wiring errors of the current three-phase four-wire power supply device, and realizes the method of effectively detecting wiring errors in advance, thereby effectively ensuring the working efficiency of three-phase four-wire power supply device and improving the intelligence of three-phase four-wire power supply device.

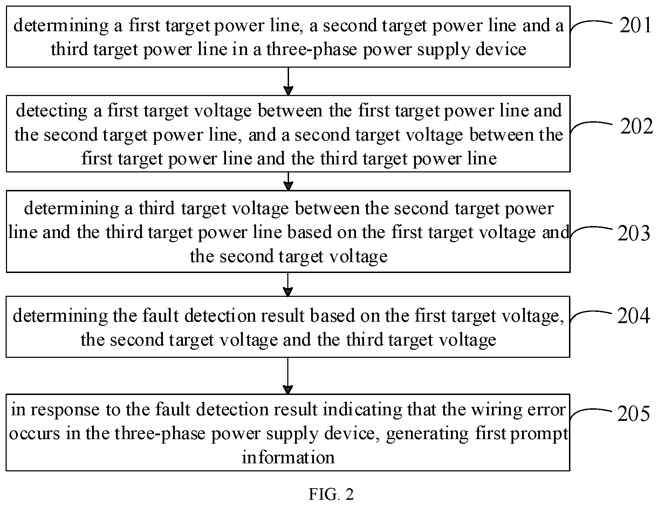

Based on the foregoing embodiments, a fault detection method is provided according to the embodiments of the present application. As shown in FIG. 2, the method is applied to fault detection device. The method includes the following steps:

Step 201: determining a first target power line, a second target power line and a third target power line in a three-phase power supply device.

The three-phase power supply device is configured to provide power for user electrical device.

In the embodiment of the present application, the voltage detection apparatus may be connected in advance to the first target power line, the second target power line and the third target power line in the three-phase power supply device. The voltage detection apparatus can be part of the fault detection device, or it can be an independent apparatus, but in any case, the fault detection device can manage and control the voltage detection apparatus.

Step 202: detecting a first target voltage between the first target power line and the second target power line, and a second target voltage between the first target power line and the third target power line.

In the embodiment of the present application, the fault detection device controls the voltage detection apparatus to detect the first target voltage between the first target power line and the second target power line, and the second target voltage between the first target power line and the third target power line. The first target voltage and the second target voltage may be detected by two voltage detection apparatuses.

It should be noted that in some application scenarios, if cost is not considered, at least two voltage detection apparatuses can be provided on the three phases and four lines of the three-phase power supply device to detect the voltage between any two power lines. During the actual demand analysis process, the first target voltage between the first target power line and the second target power line is obtained, and the second target voltage between the first target power line and the third target power line is obtained for subsequent analysis.

Step 203: determining a third target voltage between the second target power line and the third target power line based on the first target voltage and the second target voltage.

The first target voltage and the second target voltage are all line voltages or phase voltages.

In the embodiment of the present application, the first target voltage and the second target voltage are analyzed and processed according to the relationship between the voltages of the three-phases and four-wires, and then the third target voltage between the second target power line and the third target power line is determined.

Step 204: determining the fault detection result based on the first target voltage, the second target voltage and the third target voltage.

The fault detection result is configured to indicate whether a wiring error occurs in the three-phase power supply device.

In the embodiment of the present application, the first target voltage, the second target voltage and the third target voltage are analyzed to determine whether the three-phase power supply device has a fault result of wiring error.

Step 205: in response to the fault detection result indicating that the wiring error occurs in the three-phase power supply device, generating first prompt information.

The first prompt information is configured to indicate the wiring error in the three-phase power supply device.

In the embodiment of the present application, when the fault detection result indicates that the wiring error occurs in the three-phase power supply device, the first prompt information is generated and displayed.

Based on the foregoing embodiments, in other embodiments of the present application, step 203 can be implemented by steps 203a to 203b.

Step 203a: determining a target sum value of the first target voltage and the second target voltage.

In the embodiments of the present application, the sum of the first target voltage and the second target voltage is calculated to obtain the target sum.

Step 203b: determining a negative value of the target sum to obtain the third target voltage.

In the embodiment of the present application, the target sum value is negative processed to obtain the third target voltage.

Based on the foregoing embodiments, in other embodiments of the present application, step 204 can be implemented by steps 204a to 204c.

Step 204a: determining a first voltage effective value corresponding to the first target voltage, a second voltage effective value corresponding to the second target voltage, and a third voltage effective value corresponding to the third target voltage.

In the embodiment of the present application, when the thermal effects of alternating current and direct current of a certain voltage are equal, the voltage of the direct current can be considered to be the effective value of the alternating

$$U=\sqrt{\frac{1}{T}\int_0^T u(t)dt}$$

current voltage. The effective value of the corresponding voltage can be calculated by the formula . $u(t)$ is the first target voltage signal or the second target voltage signal, T is the voltage change period, and $\int$ is the integral operation symbol. Under ideal circumstances, taking the target voltage signal of the three-phase power supply device as a sinusoidal voltage signal as an example, the corresponding effective voltage value can be calculated by dividing the voltage peak value of the sinusoidal voltage signal by the radical sign 2.

Step 204b: determining a first maximum effective value and a first minimum effective value from the first voltage effective value, the second voltage effective value and the third voltage effective value.

Step 204c: determining the fault detection result based on the first maximum effective value and the first minimum effective value.

Based on the foregoing embodiments, in other embodiments of the present application, step 204c can be implemented by steps a11 to a12.

Step a11: determining a first ratio of the first maximum effective value to the first minimum effective value.

In the embodiment of the present application, the first ratio equals to the first maximum effective value being divided by the first minimum effective value.

Step a12: in response to the first ratio being greater than or equal to a first threshold, determining the fault detection result to be the wiring error occurring in the three-phase power supply device.

In the embodiment of the present application, the first threshold is an empirical value obtained based on a large number of implementations. The first threshold is greater than 1, less than or equal to $\sqrt{3}$, the symbol $\sqrt{\phantom{3}}$ is a radical sign. In an embodiment, the first threshold is greater than or equal to 1.1 and less than or equal to 1.7.

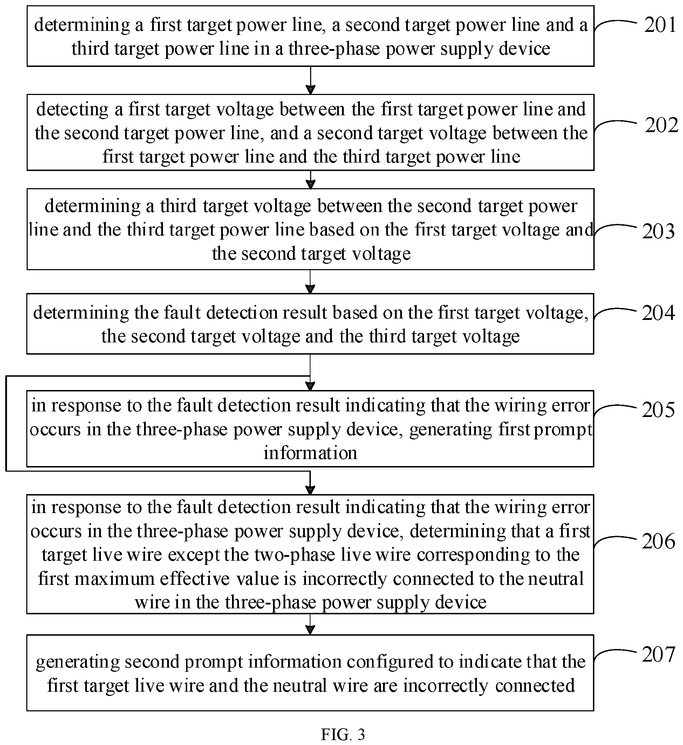

Based on the foregoing embodiments, in other embodiments of the present application, when the first target voltage and the second target voltage are both line voltages, as shown in FIG. 3, after the fault detection device performs step 204, it is further configured to perform steps 206 to 207.

Step 206: in response to the fault detection result indicating that the wiring error occurs in the three-phase power supply device, determining that a first target live wire except the two-phase live wire corresponding to the first maximum effective value is incorrectly connected to the neutral wire in the three-phase power supply device.

In the embodiment of the present application, since the line voltage is the voltage between two live wires, the first target live wire except the two-phase live wire corresponding to the first maximum effective value can be determined.

Step 207: generating second prompt information configured to indicate that the first target live wire and the neutral wire are incorrectly connected.

It should be noted that step 207 can be executed at the same time as step 205, and step 205 can also be executed after step 207. In this way, the user can be accurately notified that the first target live wire and neutral wire are incorrectly connected, so that the user can quickly correct the connection method.

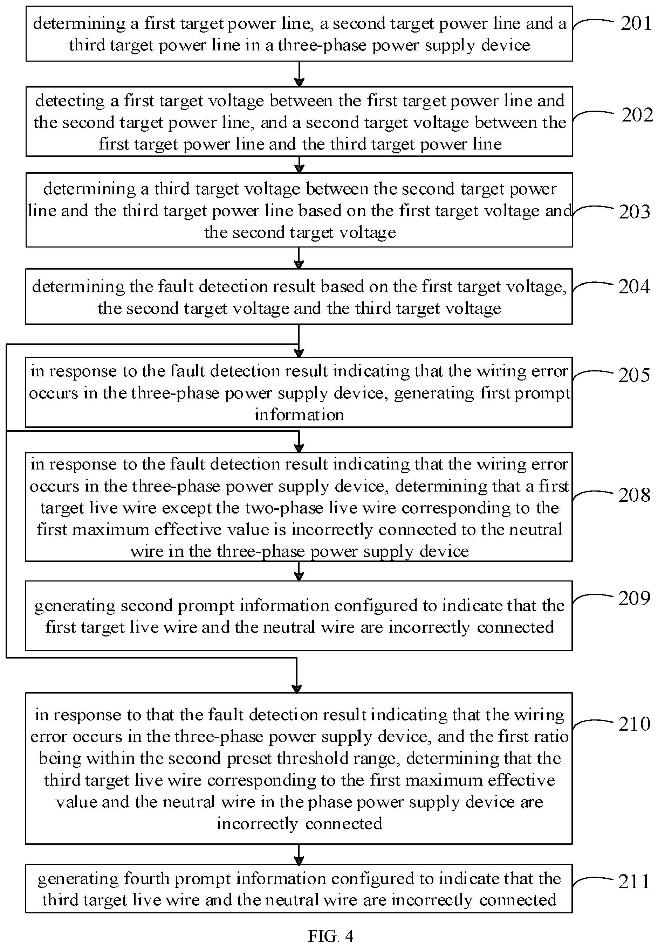

Based on the foregoing embodiments, in other embodiments of the present application, when the first target voltage and the second target voltage are both phase voltages, as shown in FIG. 4, after the fault detection device performs step 204, it is further configured to perform steps 208 to 209 or steps 210 to 211. In response to the fault detection result indicating that the wiring error occurs in the three-phase power supply device, and the first ratio being within the first preset threshold range, steps 208 to 209 are selected to be executed. In response to that the fault detection result indicating that the wiring error occurs in the three-phase power supply device, and the first ratio being within the second preset threshold range, steps 210 to 211 are selected to be executed.

Step 208: in response to the fault detection result indicating that the wiring error occurs in the three-phase power supply device, and the first ratio being within the first preset threshold range, determining that the second target live wire corresponding to the first minimum effective value and the neutral wire in the three-phase power supply device are incorrectly connected.

In the embodiments of the present application, the first preset threshold range is a preset threshold range determined based on experience. The first preset threshold range can be recorded as $[\sqrt{3},\sqrt{7}]$, and the first preset threshold range includes $\sqrt{3}$ and $\sqrt{7}$. Since the phase voltage is the voltage value between the live wire and the neutral wire, the first target voltage and the second target voltage are both phase voltage. Therefore, the third target obtained by calculation voltage is also the phase voltage. In this way, when the first minimum effective value is determined from the first target voltage, the second target voltage and the third target voltage, the second target live wire corresponding to the first minimum effective value can be determined. At this time, it can be determined that the second target live wire and the neutral wire in the three-phase power supply device are incorrectly connected.

Step 209: generating third prompt information configured to indicate that the second target live wire and the neutral wire are incorrectly connected.

In the embodiments of the present application, step 209 may be executed simultaneously with step 205 or may be executed after step 205.

Step 210: in response to that the fault detection result indicating that the wiring error occurs in the three-phase power supply device, and the first ratio being within the second preset threshold range, determining that the third target live wire corresponding to the first maximum effective value and the neutral wire in the phase power supply device are incorrectly connected.

The minimum value in the first preset threshold range is greater than or equal to the maximum value in the second preset threshold range.

In the embodiments of the present application, the second preset threshold range is a preset threshold range determined based on experience. The second preset threshold range can be recorded as $[1,\sqrt{3}]$, and the second

preset threshold range includes 1 and $\sqrt{3}$.

Step 211: generating fourth prompt information configured to indicate that the third target live wire and the neutral wire are incorrectly connected.

In the embodiment of the present application, step 211 may be executed simultaneously with step 205 or may be executed after step 205.

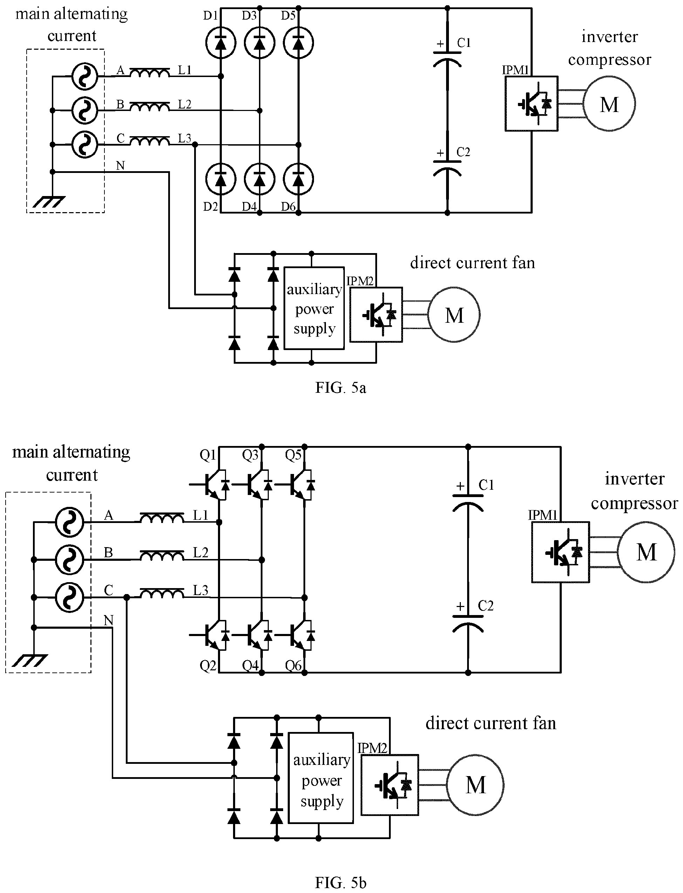

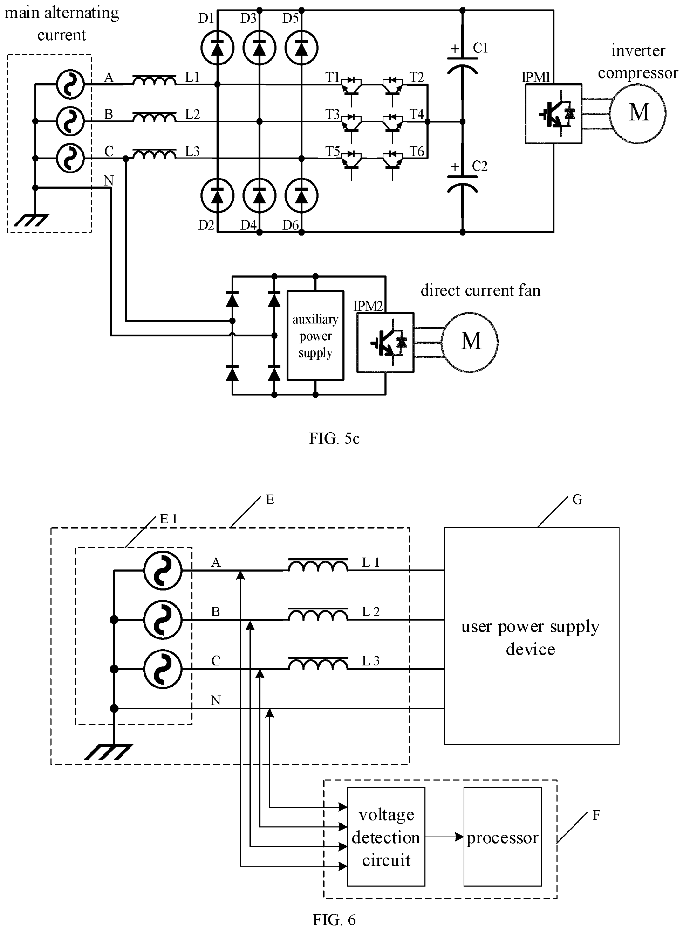

For example, assuming that the user electrical device is an inverter compressor including a main circuit for driving the inverter compressor, an auxiliary circuit for independently rectifying the auxiliary power supply, and a circuit topology diagram of a three-phase passive PFC device that supplies power to the DC fan drive circuit is shown as FIG. 5a; including a main circuit for driving the inverter compressor, an auxiliary circuit for independently rectifying the auxiliary power supply, and a circuit topology diagram of a three-phase active PFC two-level device that supplies power to the DC fan drive circuit is shown as FIG. 5b; including a main circuit for driving the inverter compressor, an auxiliary circuit for independently rectifying the auxiliary power supply, and a circuit topology diagram of a three-phase active PFC three-level device that supplies power to the DC fan drive circuit is shown as FIG. 5c.

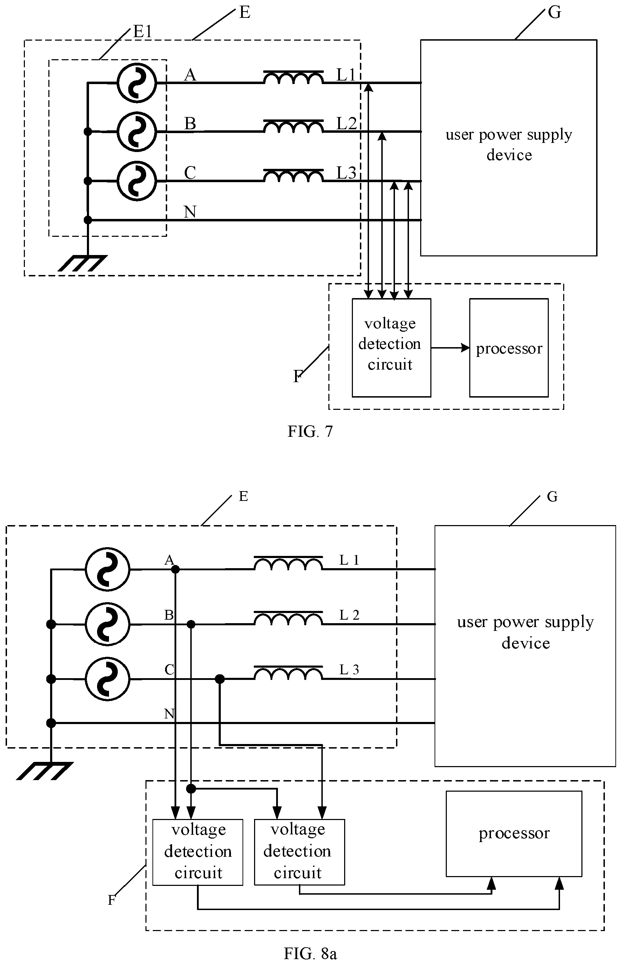

As shown in FIG. 6 or FIG. 7, the connection method between the three-phase power supply device E and the voltage detection apparatus F is illustrated. The power output end of the three-phase power supply device E is electrically connected to the user power supply device G. In FIGS. 6 and 7, the three-phase power supply device E includes: a main alternating current E1, three resistors L1, L2 and L3 provided on the three live wires A, B and C, and the neutral wire N; the voltage detection apparatus F including the voltage detection circuit and the processor. In FIG. 6, the voltage detection apparatus F is provided on a side of the current input end of the three resistors L1, L2 and L3. In FIG. 7, the voltage detection apparatus F is provided on a side of the current output end of the three resistors L1, L2 and L3.

The voltage detection circuits in FIGS. 6 and 7 are configured to detect the analog voltage between the two voltage lines whose voltage needs to be detected, and send the detected analog voltage to the processor. The processors in FIGS. 6 and 7 are configured to implement the following three steps: F21, performing analog-to-digital (A/D) conversion to the received analog voltage to obtain a numerical voltage value; F22, performing power supply wiring error diagnose and analysis on the logarithmic value to obtain the fault detection result; F23, generating the corresponding prompt information based on the fault detection result. In some application scenarios, the processor may be a microcontroller.

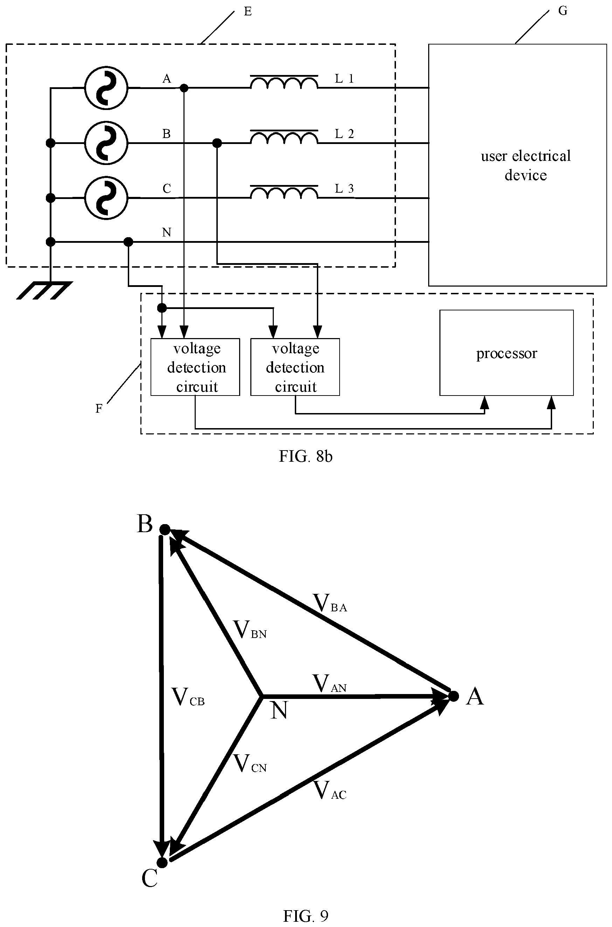

Based on the connection method between the three-phase power supply device E and the voltage detection apparatus F shown in FIG. 6, the specific connection schematic diagram when the voltage detection apparatus F includes two voltage detection circuits can be shown as FIGS. 8a to 8b. FIG. 8a is a schematic diagram of a circuit connection for detecting two line voltages, and FIG. 8b is a schematic diagram of a circuit connection for detecting two phase voltages.

After detecting the voltage $V_{BA}$ between the live wire A and the live wire B and the voltage $V_{CB}$ between the live wire B and the live wire C through the voltage detection circuit connection diagram shown in FIG. 8a, the line voltage $V_{AC}$ between the live wire A and the live wire C can be calculated through the formula $V_{AC} = -(V_{BA} + V_{CB})$. Then, whether there is an occasion in the input line wiring that the neutral wire is incorrectly connected is determined according to the voltage $V_{BA}$, voltage $V_{CB}$, and voltage $V_{AC}$. When it is determined that there is the occasion in the input line wiring that the neutral wire is incorrectly connected, the specific implementation process is: calculating the effective voltage values $U_{BA}$, $U_{CB}$ and $U_{AC}$ corresponding to the voltage $V_{BA}$, voltage $V_{CB}$ and voltage $V_{AC}$ respectively; determining the maximum voltage effective value $U_{max}$ and the minimum voltage effective value $U_{min}$ from the voltage effective values $U_{BA}$, $U_{CB}$ and $U_{AC}$; calculating the ratio k of the maximum voltage effective value and the minimum voltage effective value through the formula $k=U_{max}/U_{min}$; determining the relationship between k and the threshold K, the value range of K is $1 < K \leqslant \sqrt{3}$, and the priority value range of K is [1.1,1.7]. In response to that k is greater than K, it is determined that the neutral wire is incorrectly connected. In addition, when it is determined that the neutral wire is incorrectly connected, it can further be determined that the third phase line except the two lines corresponding to the maximum effective voltage value is reversely connected to the neutral wire N. For example, assuming that the maximum effective voltage value is $U_{BA}$, it can be ensured that the live wire C except the live wire A and the live wire B is reversely connected to the neutral wire.

After two line voltages are detected, Vm is recorded as the voltage vector magnitude. The corresponding voltage vector calculation method of another line voltage can be referred to Table 1.

Table 1

| Wiring status | | | | | | $V_{BA}$ detection | $V_{CB}$ detection | Calculate $V_{AC}$ |
|---|---|---|---|---|---|---|---|---|
| 1 | A | B | C | N | normal | $V_{BA}$ | $V_{CB}$ | $-(V_{BA}+V_{CB})$ |
| | | | | | vector magnitude | $\sqrt{3}\,\mathrm{Vm}$ | $\sqrt{3}\,\mathrm{Vm}$ | $\sqrt{3}\,\mathrm{Vm}$ |

(continued)

| Wiring status | | | | | | $V_{BA}$ detection | $V_{CB}$ detection | Calculate $V_{AC}$ |
|---|---|---|---|---|---|---|---|---|
| 2 | N | B | C | A | A-N | $V_{BN}$ | $V_{CB}$ | -($V_{BN}$+$V_{CB}$) |
| | | | | | reversely connected | | | |
| | | | | | vector magnitude | Vm | $\sqrt{3}\,Vm$ | Vm |
| 3 | A | N | C | B | B-N reversely connected | $V_{NA}$ | $V_{CN}$ | -($V_{NA}$+$V_{CN}$) |
| | | | | | vector magnitude | Vm | Vm | $\sqrt{3}\,Vm$ |
| 4 | A | B | N | C | C-N reversely connected | $V_{BA}$ | $V_{NB}$ | - ($V_{BA}$+$V_{NB}$) |
| | | | | | vector magnitude | $\sqrt{3}\,Vm$ | Vm | Vm |

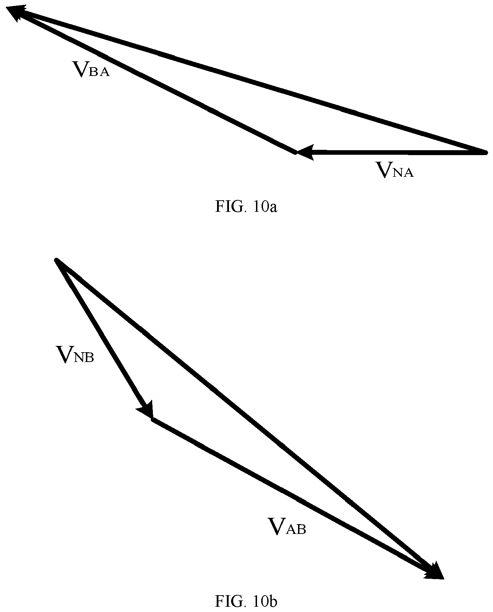

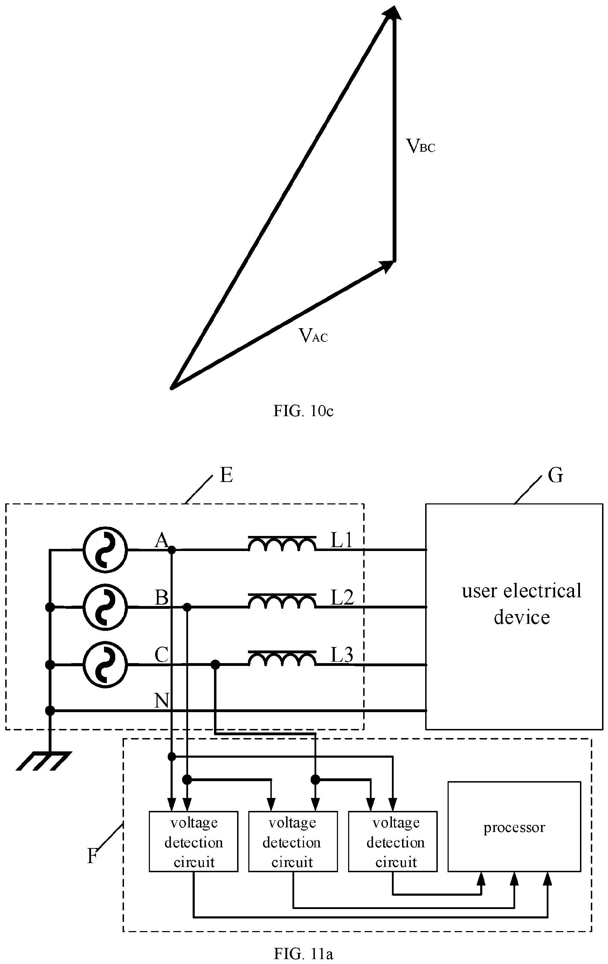

After detecting the phase voltage $V_{AN}$ between the live wire A and the neutral wire N and the phase voltage $V_{BN}$ between the live wire B and the neutral wire N through the voltage detection circuit connection diagram shown in FIG. 8b, the line voltage $V_{CN}$ between the live wire C and the neutral wire N are calculated through the formula $V_{CN}$ = -($V_{AN}$ + $V_{BN}$). Then, whether there is an occasion in the input line that the neutral wire is incorrectly connected is determined according to the voltage $V_{AN}$, the voltage $V_{BN}$ and the voltage $V_{CN}$. When it is determined that there is the occasion in the input line wiring that the neutral wire is incorrectly connected, the specific implementation process is: calculating the effective voltage values $U_{AN}$, $U_{BN}$ and $U_{CN}$ corresponding to the voltage $V_{AN}$, voltage $V_{BN}$ and voltage $V_{CN}$ respectively; determining the maximum voltage effective value $U_{max}$ and the minimum voltage effective value $U_{min}$ from the voltage effective values $U_{AN}$, $U_{BN}$ and $U_{CN}$; calculating the ratio k of the maximum voltage effective value and the minimum voltage effective value through the formula $k=U_{max}/U_{min}$; determining the relationship between k and the threshold K, the value range of K is $1<K\leqslant\sqrt{3}$, and the priority value range of K is [1.1,1.7]. In response to that k is greater than K, it is determined that the neutral wire is incorrectly connected. Furthermore, in response to that the value range of k is $\sqrt{3}<k\leqslant\sqrt{7}$, it can be determined that the live wire and the neutral wire included in the minimum effective voltage value are reversely connected. For example, assuming $U_{min}$ =$U_{CN}$, it can be determined that the live wire C and the neutral wire N are incorrectly connected; in response to that the value range of k is $1<k\leqslant\sqrt{3}$, it can be determined that the live wire and the neutral wire included in the maximum effective voltage value are reversely connected. For example, in response to $U_{max}$ =$U_{BN}$, it can be determined that the live wire B and the neutral wire N are incorrectly connected. The schematic diagram of the voltage vector between the live wires A, B and C and the neutral wire N in the three-phase four-wire system can be shown as FIG. 9. In the present application scenario, the $V_{CN}$ operation schematic diagram after the live wire A and the neutral wire N are reversely connected can be shown as FIG. 10a. The $V_{CN}$ operation schematic diagram after the live wire B and the neutral wire N are reversely connected can be shown as FIG. 10b. The schematic diagram of $V_{CN}$ operation after the live wire C and neutral wire N are reversely connected can be shown as FIG. 10c.

After two phase voltages are detected, Vm is recorded as the voltage vector magnitude. The corresponding voltage vector calculation method of the other phase voltage can be referred to Table 2.

Table 2

| Wiring status | | | | | | $V_{AN}$ detection | $V_{BN}$ detection | Calculate $V_{CN}$ |
|---|---|---|---|---|---|---|---|---|
| 1 | A | B | C | N | normal | $V_{AN}$ | $V_{BN}$ | $-(V_{AN}+V_{BN})$ |
| | | | | | vector magnitude | Vm | Vm | Vm |
| 2 | N | B | C | A | A-N reversed | $V_{NA}$ | $V_{BA}$ | $-(V_{NA}+V_{BA})$ |
| | | | | | vector magnitude | Vm | $\sqrt{3}\,Vm$ | $\sqrt{7}\,Vm$ |
| 3 | A | N | C | B | B-N reversed | $V_{AB}$ | $V_{NB}$ | $-(V_{AB}+V_{NB})$ |
| | | | | | vector magnitude | $\sqrt{3}\,Vm$ | Vm | $\sqrt{7}\,Vm$ |
| 4 | A | B | N | C | C-N reversed | $V_{AC}$ | $V_{BC}$ | $-(V_{AC}+V_{BC})$ |
| | | | | | vector magnitude | $\sqrt{3}\,Vm$ | $\sqrt{3}\,Vm$ | $3 \cdot Vm$ |

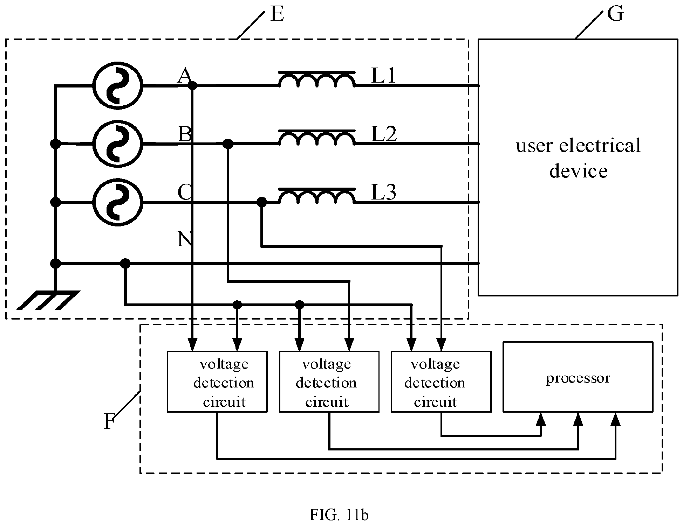

Based on the connection method between the three-phase power supply device E and the voltage detection apparatus F shown in FIG. 6, the specific connection schematic diagram when the voltage detection apparatus F includes three voltage detection circuits can be shown as FIGS. 11a to 11b. In actual application, it is feasible to start only two of the voltage detection circuits for collecting two line voltages or two phase voltages, it is also feasible to start two of the voltage detection circuits connected to the same live wire, one of which is configured to collect the phase voltage and the other is configured to collect the line voltage.

It should be noted that for descriptions of the same steps and content in this embodiment as in other embodiments, reference may be made to the descriptions in other embodiments, and will not be described again here.

In the embodiment of the present application, after determining the first target power line, the second target power line and the third target power line in the three-phase power supply device, the first target voltage between the first target power line and the second target power line, and the second target voltage between the first target power line and the third target power line are detected, and the fault detection result based on the first target voltage and the second target voltage is determined. In response to that the fault detection result indicates that the wiring error occurs in the three-phase power supply device, the first prompt information is generated. In this way, by analyzing the first target voltage between the first target power line and the second target power line, and the second target voltage between the first target power line and the third target power line, it can be determined that whether the wiring error occurs in the three-phase power supply device. Therefore, the present application solves the problem of the poor working efficiency caused by the wiring errors of the current three-phase four-wire power supply device, and realizes the method of effectively detecting wiring errors in advance, thereby effectively ensuring the working efficiency of three-phase four-wire power supply device and improving the intelligence of three-phase four-wire power supply device.

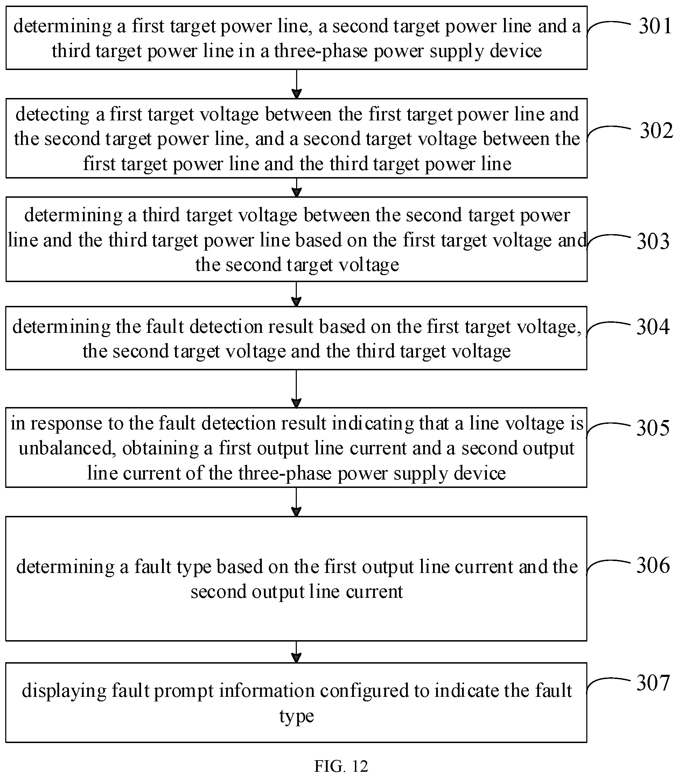

The embodiment of the present application provides a fault detection method. When the first target voltage and the second target voltage are both line voltages, as shown in FIG. 12, the method is applied to the fault detection device. The method includes the following steps:

Step 301: determining a first target power line, a second target power line and a third target power line in a three-phase power supply device.

The three-phase power supply device is configured to provide power for user electrical device.

Step 302: detecting a first target voltage between the first target power line and the second target power line, and a second target voltage between the first target power line and the third target power line.

In the embodiment of the present application, the fault detection device can detect the voltage on any two power input live wires of the three-phase power supply device through the voltage detection module in the detection circuit. In this way, the fault detection device can obtain the effective voltages detected by the detection circuit from the detection circuit. The effective voltages are the first target voltage and the second target voltage.

For example, assuming that the three live wires of a three-phase power supply device are labeled A, B, and C in sequence, in response to that the voltage detection module in the detection circuit is connected to live wires A and B, B and C, then the first target voltage $U_{AB}$ between the live wires A and B, and the second target voltage $U_{BC}$ between the live wires B and C can be detected respectively.

Step 303: determining a third target voltage between the second target power line and the third target power line based on the first target voltage and the second target voltage.

According to the line voltage relationship between the three live wires in the three-phase power supply device, the third target voltage can be determined based on the first target voltage and the second target voltage. The line voltage relationship between the three live wires in the three-phase power supply device can be expressed by the vector operation formula $U_{AB}+U_{BC}+U_{CA}=0$.

For example, according to the first target voltage $U_{AB}$ and the second target voltage $U_{BC}$, the third target voltage $U_{AC}=-U_{CA}=U_{AB}+U_{BC}$ can be calculated.

Step 304: determining the fault detection result based on the first target voltage, the second target voltage and the third target voltage.

Step 305: in response to the fault detection result indicating that a line voltage is unbalanced, obtaining a first output line current and a second output line current of the three-phase power supply device.

In the embodiment of the present application, there are usually two reasons for the unbalanced line voltage: one is the fault that the live wire and the neutral wire of the three-phase power supply device are reversely connected, and the other is the fault that the live wire is missed, that is, the phase loss fault. The line current is the current output by the live wire. When the fault detection result indicates that the line voltages of the three-phase power supply device is unbalanced, the fault detection device continues to obtain the line currents of any two live wires of the three-phase power supply device to obtain the first output line current and the second output line current.

In response to that a comparative analysis is performed based on the first target voltage, the second target voltage and the third target voltage and it is determined that the fault detection result is an unbalanced line voltage, the fault detection device controls the detection circuit and any two of the three-phase power supply device. The current detection apparatus connected to the live wire detects the current of the corresponding live wire to obtain the first output line current and the second output line current of the three-phase power supply device.

For example, when the fault detection result indicates that the line voltages is unbalanced, the current output by the live wire B and the live wire C of the three-phase power supply device is collected through the Hall sensors provided on the live wire B and the live wire C respectively, and the first output line current $I_B$ and the second output line current $I_C$ are obtained.

Step 306: determining a fault type based on the first output line current and the second output line current.

In the embodiment of the present application, according to the characteristics of the output current of the three live wires in the three-phase power supply device, the current characteristics of the first output line current and the second output line current are analyzed, and the fault type of the specific wiring fault that occurs in the three-phase power supply device can be determined. The fault types include misconnection type of the live wire and neutral wire and type of the phase loss.

For example, a comparative analysis is performed on the first output line current $I_B$ and the second output line current $I_C$ to determine the fault type. In response to that at least one of the first output line current and the second output line current is less than the first preset current threshold, the fault type is determined to be the phase loss fault, and the corresponding current less than the first preset current threshold corresponds to a live wire phase loss.

Step 307: displaying fault prompt information configured to indicate the fault type.

In the embodiment of the present application, after the specific fault type is determined, the fault prompt information is displayed, allowing the user to remove fault against the fault type according to the fault prompt information, ensuring the safety of important components in the three-phase power supply device and the safety of the load, improving the user experience and reducing losses.

The determined fault type will be displayed in the form of fault prompt information, so that users can quickly know the fault type, conduct fault troubleshooting, and reduce losses. The fault prompt information can be implemented in one or more forms such as text, pictures, sounds, lights, etc. The fault detection device can send the fault prompt information to a device connected to the fault detection device for display. The device connected to the fault detection device can include one or various kinds of a central control device in a smart home, a smart mobile terminal device or a remote control device.

Based on the foregoing embodiments, in other embodiments of the present application, step 304 can be implemented by steps 304a to 304c.

Step 304a: determining a maximum line voltage and a minimum line voltage from the first target voltage, the second target voltage, and the third target voltage.

In the embodiment of the present application, the maximum line voltage and the minimum line voltage are obtained by comparing the value of the first target voltage, the second target voltage and the third target voltage. For example, when determining the maximum line voltage and the minimum line voltage from the first target voltage $U_{AB}$, the second target voltage $U_{BC}$ and the third target voltage $U_{AC}$, the absolute values of the first target voltage $U_{AB}$, the second target voltage $U_{BC}$, and the third target voltage $U_{BC}$ are compared and analyzed, and it is assumed that the maximum line voltage obtained is $U_{AB}$ and the minimum line voltage obtained is $U_{BC}$.

Step 304b: determining a ratio of the maximum line voltage to the minimum line voltage.

In the embodiment of the present application, the determined ratio b between the maximum line voltage and the minimum line voltage is obtained through the formula b=maximum line voltage/minimum line voltage. For example, the obtained ratio is determined to be $b=U_{AB}/U_{BC}$.

Step 304c: in response to the ratio being greater than or equal to a preset threshold, determining the fault detection result is that the line voltage is unbalanced.

In the embodiment of the present application, the preset threshold is an empirical value obtained based on a large number of experimental analyses. The preset threshold ranges from 1 to 2, for example, can be 1.5. For example, in response to that $U_{AB}/U_{BC}$ is greater than or equal to 1.5, it is determined that the fault detection result is an unbalanced line voltage. In response to that the ratio is greater than the preset threshold, it is determined that the fault detection result is a voltage balance between lines, that is, there is no fault. Therefore, no subsequent analysis is required and only the monitoring operation is required to be performed normally.

Based on the foregoing embodiments, in other embodiments of the present application, step 306 can be implemented by steps 306a to 306b.

Step 306a: determining a third output line current based on the first output line current and the second output line current.

In the embodiment of the present application, the vector relationship between the three-phase line currents in the three-phase power supply device is $I_A+I_B+I_C=0$. In this way, knowing the corresponding line currents of two of the phases, the third output line current can be calculated.

For example, after detecting the first output line current $I_B$ and the second output line current $I_C$, the third output line current $I_A=-(I_B+I_C)$ can be calculated.

Step 306b: determining the fault type based on the first output line current, the second output line current and the third output line current.

In the embodiment of the present application, the specific fault type can be determined by comparing and analyzing the first output line current, the second output line current and the third output line current.

Based on the foregoing embodiments, in other embodiments of the present application, step 306b can be implemented by steps b11 to b12.

Step b11: in response to a slave relay connected to a power factor correction apparatus in the three-phase power supply device being conducted, determining a minimum line current from the first output line current, the second output line current and the third output line current.

The slave relay is connected in series between a main circuit and a main AC power supply.

In the embodiment of the present application, the situation in which the slave relay is conducted is usually the application scenario when the three-phase power supply device is initially powered on. That is to say, when the three-phase power supply device is initially powered on, the slave relay of the three-phase power supply device is turned on. At this time, the first target voltage and the second target voltage are collected, and then fault analysis is performed on the first target voltage and the second target voltage. When it is determined that the fault detection result indicates that the line voltages is unbalanced, the first output line current and the first output line current and the second target voltage are continuously obtained. After the third output line current is determined based on the first output line current and the second output line current, a value comparison analysis on the first output line current, the second output line current and the third output line current is performed to determine the minimum line current. It should be noted that the current values of the first output line current, the second output line current and the third output line current are all positive values greater than or equal to 0. The minimum line current includes at least one line current.

Step b12: in response to the minimum line current being less than or equal to a first preset current threshold, determining the fault type to be a phase loss fault.

In the embodiment of the present application, the first preset current threshold is an empirical value obtained based on a large number of experiments, and the first preset current threshold ranges from 0 to 1 ampere (A), including 0 and 1. For example, taking the first preset current threshold as 1A as an example, in response to that the minimum line current is less than or equal to 1A, the fault type is determined to be the phase loss fault.

Based on the foregoing embodiments, in other embodiments of the present application, after the fault detection device performs step b12, it is further configured to perform steps b13 to b15.

Step b13: determining the first target live wire corresponding to the minimum line current.

In the embodiment of the present application, after determining that the fault type is a phase loss fault, the live wire corresponding to the minimum line current is determined to obtain the first target live wire.

Step b14: generating fifth prompt information configured to indicate the first target live wire phase loss.

In the embodiments of the present application, based on the obtained first target live wire, fifth prompt information indicating a defect in the first target live wire is generated.

Step b15: displaying the fifth prompt information.

In the embodiment of the present application, the fifth prompt information may be one or several combinations of prompt information in the form of text, picture, sound, light, etc., and may be displayed in the display area corresponding to the fault detection device, or may be displayed in the device communicated to the fault detect device. In this way, the user can determine the specific fault location based on the fifth prompt information, achieve rapid fault positioning and fault solving, improve the fault resolution efficiency, ensure the safety of the three-phase power supply device, and reduce the load and possibility of damage to precision instruments in the three-phase power supply device.

Based on the foregoing embodiments, in other embodiments of the present application, after the fault detection device performs step b11, it may also choose to perform step b16:

Step b16: in response to the minimum line current being greater than the first preset current threshold, determining the fault type to be a wiring error type.

In the embodiment of the present application, the type of wiring error is the type of the incorrect connection between the neutral wire and the live wire.

Based on the foregoing embodiments, in other embodiments of the present application, after the fault detection device performs step b16, it is further configured to perform steps b17 to b18.

Step b17: in response to determining that the second target live wire and the neutral wire are incorrectly connected based on the first target voltage, the second target voltage and the third target voltage, generating sixth prompt information configured to indicate that the second target live wire and the neutral wire are incorrectly connected.

In the embodiment of the present application, after it is determined that the fault type is a wiring error, the first target voltage, the second target voltage and the third target voltage are continuously analyzed to determine the specific live wire of the wiring error. The process of analyzing the first target voltage, the second target voltage and the third target voltage can be: sorting the first target voltage, the second target voltage and the third target voltage according to the size relationship to obtain the maximum voltage, the intermediate voltage and the minimum voltage; determining the first ratio between the maximum voltage and the minimum voltage, and the second ratio between the intermediate voltage and the minimum voltage; determining the difference between $\sqrt{3}$ and the preset error coefficient to obtain the first threshold, and determining the sum of the $\sqrt{3}$ and the preset error coefficient value to obtain the second threshold; and determining the sum of 1 and the preset error coefficient to obtain the third threshold. The preset error coefficient is greater than or equal to 0 and less than or equal to 0.3; in response to that the first ratio is greater than or equal to the first threshold, the first ratio is less than or equal to the second threshold, the second ratio is greater than or equal to 1, the second ratio is less than or equal to the third threshold, and the live wire corresponding to the maximum voltage does not include the live wire configured to provide power for the fault detection device, the second target live wire is determined to be the live wire configured to provide power for the fault detection device. In response to that the first ratio is greater than or equal to the first threshold, the first ratio is less than or equal to the second threshold, the second ratio is greater than or equal to 1, the second ratio is less than or equal to the third threshold, and the live wire corresponding to the maximum voltage includes the live wire configured to provide power for the fault detection device, the second target live wire is determined to be the live wire B except the two live wires A and C corresponding to the maximum voltage in the three-phase power supply device, for example, $U_{AC}$. That is, the second target live wire is the live wire B. In this way, after determining the second target live wire that is incorrectly connected based on the first target voltage, the second target voltage, and the third target voltage, the sixth information is generated to remind the user that the second target live wire and the neutral wire are incorrectly connected.

Step b18: displaying the sixth prompt information.

In the embodiment of the present application, the sixth prompt information may be one or various combinations of prompt information in the form of text, picture, sound, light, etc., and may be displayed in the display area corresponding to the fault detection device, or may be displayed in the device communicated to the fault detection device.

Based on the foregoing embodiments, in other embodiments of the present application, step 306b can be implemented by steps c11 to c12.

Step c11: in response to a main relay in the three-phase power supply device being conducted, determining the minimum line current from the first output line current, the second output line current and the third output line current.

In the embodiment of the present application, after the slave relay is disconnected and the main relay is controlled to be conducted, and it is determined that the fault detection result indicates that the line voltages is unbalanced, the first output line current and the second output line current are continued to be collected, and after the third output line current is determined based on the first output line current and the second output line current, the first output line current, the second output line current and the third output line current are analyzed in size to determine the minimum line current.

Step c12: in response to the minimum line current being less than or equal to the second preset current threshold, and all current among the first output line current, the second output line current and the third output line current except the minimum line current being greater than or equal to the third preset current threshold, determining the fault type to be the phase loss fault.

The third preset current threshold is greater than the second preset current threshold.

In the embodiments of the present application, the second preset current threshold is an empirical value obtained based on a large number of experiments. For example, the second preset current threshold may be greater than 0 and less than or equal to 1A. The third preset current threshold is an empirical value obtained based on a large number of experiments. According to the empirical value obtained from the experiment, the third preset power threshold is greater than or equal to 3A and less than or equal to 6A. For example, in response to the minimum line current, for example, $I_A$ is less than or equal to 1A, and both $I_B$ and $I_C$ are greater than or equal to 5A, the fault type is determined to be the phase loss fault.

Based on the foregoing embodiments, in other embodiments of the present application, after the fault detection device performs step c12, it is further configured to perform steps c13 to c15.

Step c13: determining the second target live wire corresponding to the minimum line current.

Step c14: generating seventh prompt information configured to indicate the second target live wire phase loss.

Step c15: displaying the seventh prompt information.

Based on the foregoing embodiments, in other embodiments of the present application, after the fault detection device performs step c12, it is further configured to perform step c16.

Step c16: in response to detecting that at least one of the first output line current, the second output line current and the third output line current is greater than or equal to a fourth preset current threshold, controlling a main relay of the three-phase power supply device to be in an off state and a load of the three-phase power supply device to be in a shutdown state.

The fourth preset current threshold is greater than the third preset current threshold.

In the embodiment of the present application, the fourth preset current threshold is an empirical value obtained based on a large number of experiments, and the fourth preset current threshold is greater than or equal to 9A. In response to that the main relay is turned on, after determining that the fault type is a phase loss fault, the first output line current and the second output line current are continued to be monitored, and the third output line current is determined. In response to that at least one of the first output line current and the second output line current and the third output line currents appears to be equal to the fourth preset current threshold, such as 10A, the fault detection device controls the main relay to be disconnected, and controls the load of the three-phase power supply device to be in a shutdown state and no longer work. In this way, the safety of circuit components in the three-phase power supply device is protected, and the safety of the load is also protected, preventing the load from being burned out and reducing losses.

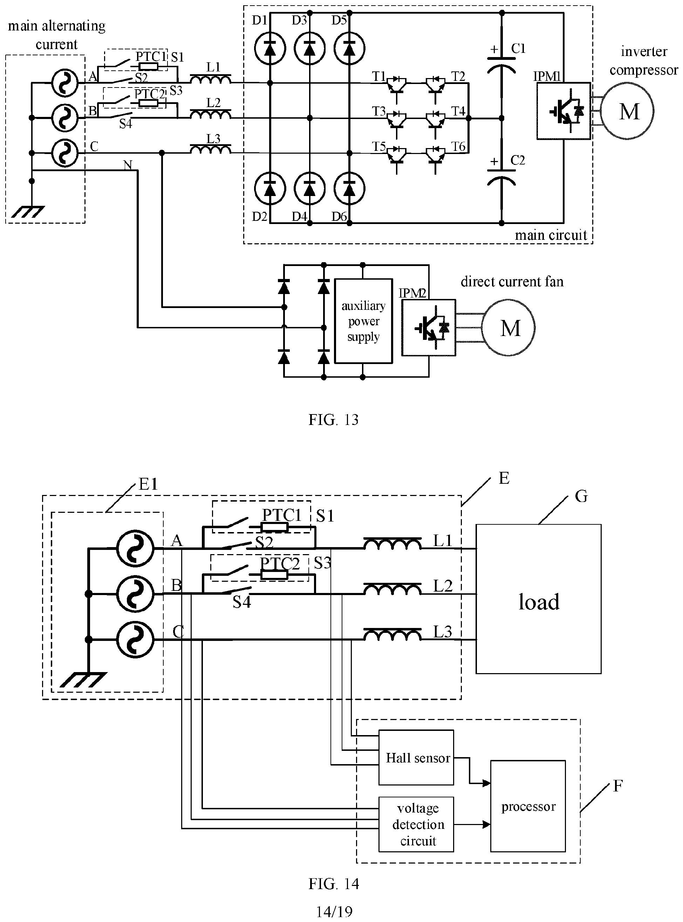

For example, assuming that the user electrical device is an inverter compressor including a main circuit for driving the inverter compressor, an auxiliary circuit for independently rectifying the auxiliary power supply, and a circuit topology diagram of a three-phase active PFC three-active device circuit that supplies power to the DC fan drive circuit is shown as FIG. 13. The live wire A of the three-phase power supply device is connected with the slave relay S1 and the main relay S2. The slave relay S1 and the main relay S2 are connected in parallel. The live wire B is connected with the slave relay S3 and the main relay S4. The slave relay S3 and the main relay S4 are connected in parallel.

As shown in FIG. 14, the connection method between the three-phase power supply device E and the fault detection device F is shown. The power output end of the three-phase power supply device E is electrically connected to the load G. As shown in FIG. 14, the three-phase power supply device E includes: main alternating current E1, three resistors L1, L2 and L3 provided on the three live wires A, B and C, and a slave relay S1 and main relay S2 provided in front of the resistor L1 of the live wire A, a slave relay S3 and main relay S4 provided in front of the resistor L2 of the live wire B. The fault detection device F includes a voltage detection circuit, a Hall sensor and a processor. The circuit structure of the main circuit in FIG. 14 is not shown.

The voltage detection circuit in FIG. 14 is configured to detect the analog voltage between any two sets of connected live wires, and sends the detected analog voltage to the processor. The Hall sensor is configured to detect the output current between any two connected live wires. The processor in FIG. 14 is configured to implement the following processes.

Step 1: the three-phase power supply device is powered on, the processor, for example, can be a micro controller unit (MCU) for initialization. After the MCU is initialized, it controls the switches of slave relays S1 and S3 to control the PTC resistor to connect to the circuit.

Step 2: the MCU controls the voltage detection circuit to collect the voltage, for example, the line voltage $U_{AB}$ and the line voltage $U_{BC}$ are collected. After signal conditioning, the values are sent to the MCU. The MCU calculates the line voltage $U_{CA}$ between the live wire A and the live wire C according to the line voltage $U_{AB}$ and line voltage $U_{BC}$ values.

The vector operation diagram of the corresponding line voltages between the live wire A, the live wire B and the live wire C can be shown in FIG. 9. In FIG. 9, N is the neutral wire, which satisfies the vector operation relationship of $U_{AB}+U_{BC}+U_{CA}=0$.

Step 3: the MCU determines the line voltage $U_{AB}$, line voltage $U_{BC}$ and line voltage $U_{CA}$. In response to that any line voltage is greater than or equal to a certain value of any other line voltage, such as more than 1.5 times, then the power supply line space of the three-phase power supply device is determined to be unbalanced.

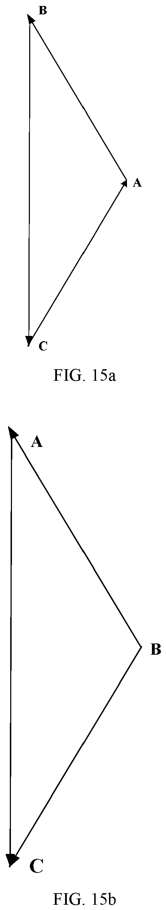

For example, FIG. 15a shows a schematic diagram of the corresponding line voltage vector distribution when the live wire A and the neutral wire N are incorrectly connected. FIG. 15b shows a schematic diagram of the corresponding line voltage vector distribution when the live wire B and the neutral wire N are incorrectly connected.

Step 4: the MCU controls the Hall sensor to detect the output current $I_B$ and $I_C$ and of the live wire B and the live wire C after the slave relay is conducted. After the MCU receives $I_B$ and $I_C$, the current $I_A$ of live wire A is calculated based on $I_B$ and $I_C$. In response to that the current of any phase among $I_A$, $I_B$ and $I_C$ is less than a certain current value, such as 1A, the live wire corresponding to the current less than a certain current value is determined, a phase-loss fault information is generated, and the fault information is displayed while displaying the phase loss of the live wire corresponding to the current less than a certain current value; otherwise the fault information is a fault of wiring error.

Step 5: In response to that the line voltage of the power supply of the three-phase power supply device is determined in step 3, after a delay, the MCU controls the main relay to be conducted, delays the disconnection of the PTC relay, and enters the standby state.

Step 6: After the MCU detects that the rectifier is running, the MCU controls the voltage detection circuit to collect the voltage. For example, the line voltage $U_{AB}$ and the line voltage $U_{BC}$ are collected. After signal conditioning, the values are sent to the MCU. The MCU calculates the line voltage $U_{CA}$ between the live wire A and the live wire C based on the line voltage $U_{AB}$ and line voltage $U_{BC}$ values.

Step 7: The MCU determines the line voltage $U_{AB}$, line voltage $U_{BC}$ and line voltage $U_{CA}$. In response to that any line voltage is greater than or equal to a certain value such as 1.5 times or more of any other line voltage, then the line voltage of the power supply of the three-phase power supply device is determined to be unbalanced.

Step 8: the MCU controls the Hall sensor to detect the output current $I_B$ and $I_C$ and of the live wire B and the live wire C after the slave relay is conducted. After the MCU receives $I_B$ and $I_C$, the current $I_A$ of live wire A is calculated based on $I_B$ and $I_C$. In response to that the current of any phase among $I_A$, $I_B$ and $I_C$ is less than a certain current value, such as 1A, and the other two current values are both greater than a certain current value, such as 5A, the live wire corresponding to the current less than 1A is determined, a phase-loss fault information is generated, and the fault information is displayed while specifically displaying the phase loss of the live wire corresponding to the current less than 1A.

Step 9: In response to that it is detected that the operating current continues to increase and exceeds a certain current value, such as 10A, shut down all loads and rectifiers to avoid fault expansion.

In response to that the MCU detects that the main relay is conducted after the fault prompt information is displayed to be removed in step 4, it can be selected to perform steps 5 to 9. In response to that there is no slave relay, it can be directly selected to perform the embodiments corresponding to steps 5 to 9.

It should be noted that for descriptions of the same steps and content in this embodiment as in other embodiments, reference may be made to the descriptions in other embodiments, and will not be described again here.

In the embodiment of the present application, after determining the first target power line, the second target power line and the third target power line in the three-phase power supply device, the first target voltage between the first target power line and the second target power line, and the second target voltage between the first target power line and the third target power line are detected, and the fault detection result based on the first target voltage and the second target voltage is determined. In response to that the fault detection result indicates that the line voltage is unbalanced, the first output line current and the second output line current of the three-phase power supply device is continued to be obtained, and after the fault type is determined based on the first output line current and the second output line current, the fault prompt information configured to indicate the fault type is displayed. In this way, by performing fault analysis on the first target voltage and the second target voltage, the first output line current and the second output line current of the three-phase power supply device is determined to continue being obtained in response to that the line voltage is unbalanced, and then the specific fault type is determined and displayed. Therefore, the present application solves the problem of the poor working efficiency caused by the wiring errors or the phase loss in the current three-phase four-wire power supply device, and realizes the method of effectively detecting wiring errors or phase loss in advance, thereby effectively reducing the probability of device component damage in the three-phase power supply device, and ensuring the reliability of the three-phase power supply device.

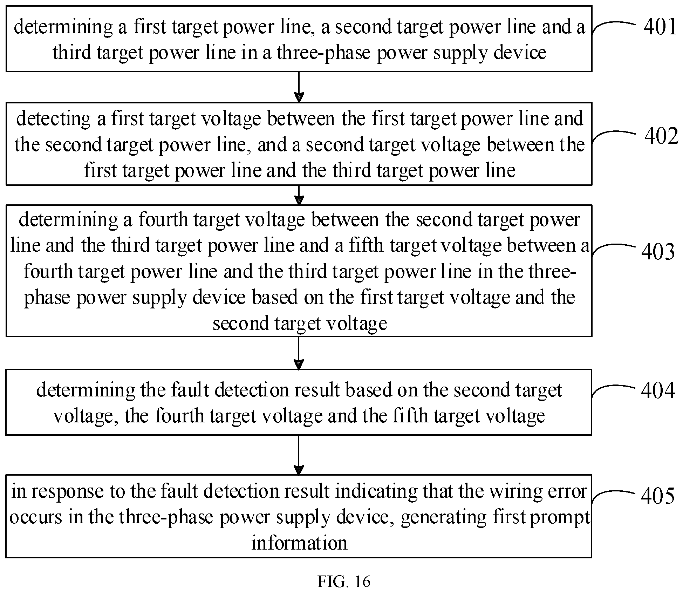

Based on the foregoing embodiments, the embodiments of the present application provide a fault detection method. In response to that the first target power line and the second target power line are the live wires in the three-phase power supply device, and the third target power line is the neutral wire in the three-phase power supply device. As shown in FIG. 16, the method is applied to the fault detection device. The method includes the following steps.

Step 401: determining a first target power line, a second target power line and a third target power line in a three-phase power supply device.

The three-phase power supply device is configured to provide power for user electrical device.

Step 402: detecting a first target voltage between the first target power line and the second target power line, and a second target voltage between the first target power line and the third target power line.

In the embodiment of the present application, during the detection process of the first target voltage and the second target voltage, they are detected on the same live wire, that is, the first target power line. At this time, the first target voltage is the line voltage, and the second target voltage is the phase voltage.

Step 403: determining a fourth target voltage between the second target power line and the third target power line and a fifth target voltage between a fourth target power line and the third target power line in the three-phase power supply device based on the first target voltage and the second target voltage.

In the embodiments of the present application, the fourth target voltage and the fifth target voltage are calculated to be the phase voltages.

Step 404: determining the fault detection result based on the second target voltage, the fourth target voltage and the fifth target voltage.

The fault detection result is configured to indicate whether a wiring error occurs in the three-phase power supply device.

In the embodiment of the present application, three phase voltages are analyzed to determine the fault detection result.

Step 405: in response to the fault detection result indicating that the wiring error occurs in the three-phase power supply device, generating first prompt information.

The first prompt information is configured to indicate the wiring error in the three-phase power supply device.

Based on the foregoing embodiments, in other embodiments of the present application, step 403 can be implemented by steps 403a to 403c.

Step 403a: determining a difference between the second target voltage and the first target voltage to obtain the fourth target voltage.

Step 403b: determining a target product of the second target voltage and 2.

Step 403c: determining a difference between the first target voltage and the target product to obtain the fifth target voltage.

In the embodiment of the present application, the fifth target voltage=the first target voltage-target product=the first target voltage-2*the second target voltage.

Based on the foregoing embodiments, in other embodiments of the present application, step 404 can be implemented by steps 404a to 404c.

Step 404a: determining a second voltage effective value corresponding to the second target voltage, a fourth voltage effective value corresponding to the fourth target voltage, and a fifth voltage effective value corresponding to the fifth target voltage.

Step 404b: determining a second maximum effective value and a second minimum effective value from the second voltage effective value, the fourth voltage effective value and the fifth voltage effective value.

Step 404c: determining the fault detection result based on the second maximum effective value and the second minimum effective value.

Based on the foregoing embodiments, in other embodiments of the present application, step 404c can be implemented by steps d11 to d12.

Step d11: determining a second ratio of the second maximum effective value to the second minimum effective value.

In the embodiment of the present application, the second ratio=the second maximum effective value/the second minimum effective value.

Step d12: in response to the second ratio being greater than or equal to the second threshold, determining the fault detection result to be the wiring error occurring in the three-phase power supply device.

In the embodiments of the present application, the second threshold may be the same as the first threshold, or may be different from the first threshold, and the second threshold may be greater than 1, less than or equal to $\sqrt{3}$. In an embodiment, the second threshold is greater than or equal to 1.1 and less than or equal to 1.7.

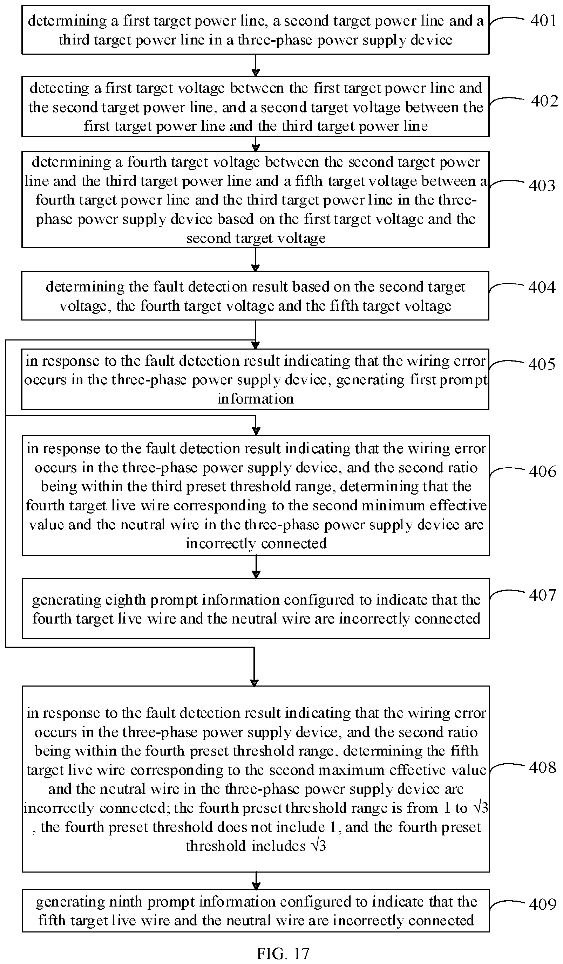

Based on the foregoing embodiments, in other embodiments of the present application, as shown in FIG. 17, after the fault detection device performs step 404, it is further configured to perform steps 406 to 407 or steps 408 to 409. In response to that the fault detection result indicates that there is a wiring error in the three-phase power supply device, and the second ratio is within the third preset threshold range, it is selected to perform steps 406 to 407. In response to that the fault detection result indicates that there is a wiring error in the three-phase power supply device, and the second ratio is within the fourth preset threshold range, it is selected to perform steps 408 to 409.

Step 406: in response to the fault detection result indicating that the wiring error occurs in the three-phase power supply device, and the second ratio being within the third preset threshold range, determining that the fourth target live wire corresponding to the second minimum effective value and the neutral wire in the three-phase power supply device are incorrectly connected.

The third preset threshold range is from $\sqrt{3}$ to $\sqrt{7}$, the third preset threshold range does not include $\sqrt{3}$, and the third preset threshold range includes $\sqrt{7}$.

Step 407: generating eighth prompt information configured to indicate that the fourth target live wire and the neutral wire are incorrectly connected.

Step 408: in response to the fault detection result indicating that the wiring error occurs in the three-phase power supply device, and the second ratio being within the fourth preset threshold range, determining the fifth target live wire corresponding to the second maximum effective value and the neutral wire in the three-phase power supply device are incorrectly connected; the fourth preset threshold range is from 1 to $\sqrt{3}$, the fourth preset threshold does not include 1, and the fourth preset threshold includes $\sqrt{3}$.

Step 409: generating ninth prompt information configured to indicate that the fifth target live wire and the neutral wire are incorrectly connected.

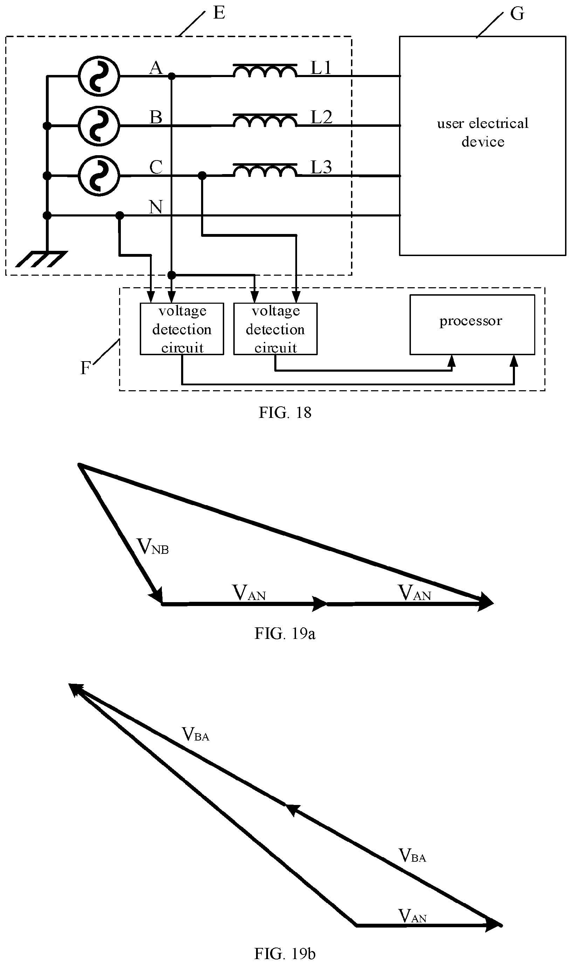

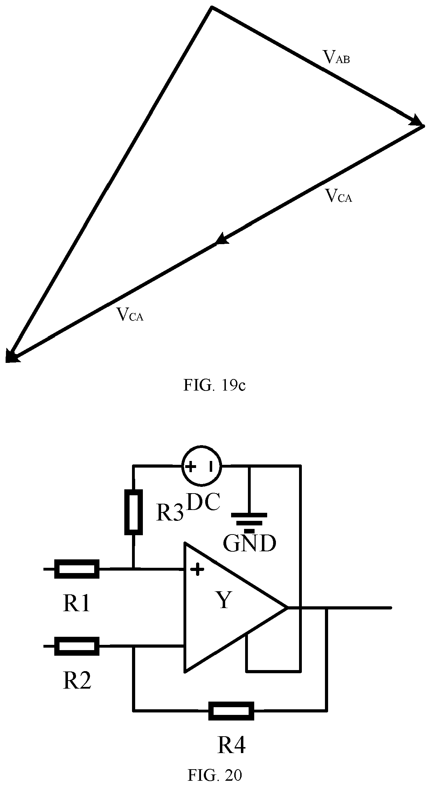

Based on the connection method between the three-phase power supply device E and the voltage detection apparatus F shown in FIG. 6, the specific connection schematic diagram when the voltage detection apparatus F includes two voltage detection circuits can be shown as FIG. 18. Taking the voltage detection circuit being configured to detect the first target voltage between the shared live wire A and the live wire B to obtain the line voltage $V_{AB}$, and a voltage detection circuit being configured to detect the second target voltage between the shared live wire A and the neutral wire N to obtain the phase voltage $V_{AN}$ as an example to illustrate. The phase voltage $V_{BN}$ between the live wire B and the neutral wire N is calculated through the formula $V_{CN}=V_{AB}-2V_{AN}$, and the live wire C is calculated through the formula $V_{CN}=V_{AB}-2V_{AN}$. Then the effective voltage values $U_{AN}$, $U_{BN}$ and $U_{CN}$ of the phase voltage $V_{AN}$, phase voltage $V_{BN}$ and phase voltage $V_{CN}$ at the same time are determined respectively. Finally, whether there is a wrong neutral connection in the input line wiring is determined according to the effective voltage values $U_{AN}$, $U_{BN}$ and $U_{CN}$. The determining whether there is a wrong neutral connection in the input line wiring according to the effective voltage values $U_{AN}$, $U_{BN}$ and $U_{CN}$ includes the following steps: determining the maximum effective voltage value $U_{max}$ from the effective voltage values $U_{AN}$, $U_{BN}$ and $U_{CN}$ and the minimum voltage effective value $U_{min}$; calculating the ratio k of the maximum voltage effective value and the minimum voltage effective value through the formula $k=U_{max}/U_{min}$; determining the relationship between k and the threshold K, the value range of K is $1<K\leqslant\sqrt{3}$, the preferred value range of K is [1.1,1.7]; in response to that k is greater than K, it is determined that the neutral wire is incorrectly connected. Furthermore, in response to that the value range of k is $\sqrt{3}<k\leqslant\sqrt{7}$, it can be determined that the live wire and the neutral wire included in the minimum effective voltage value are incorrectly connected. For example, assuming $U_{min}=U_{AN}$, it can be determined that the live wire A and the neutral wire N are incorrectly connected; in response to that the value range of k is $1<k\leqslant\sqrt{3}$, it can be determined that the live wire and the neutral wire included in the maximum effective voltage value are incorrectly connected. For example, in response to that $U_{max}=U_{CN}$, it can be determined that the live wire C and the neutral wire N are incorrectly connected. In the present application scenario, the schematic diagram of $V_{CN}$ operation after the live wire A and the neutral wire N are reversely connected can be shown as FIG. 19a. The schematic diagram of $V_{CN}$ operation after the live wire B and the neutral wire N are reversely connected can be shown as FIG. 19b. The schematic diagram of $V_{CN}$ operation after the live wire C and the neutral wire N are reversely connected can be shown as FIG. 19c.

It should be noted that the voltage detection circuit in the aforementioned FIGS. 6, 7, 8a to 8b, 11a to 11b, 14, and 18 can be shown as FIG. 20, including: resistors R1, R2, R3, and R4, operational amplifier Y, DC power supply DC, GND is the ground terminal, the two terminals where R1 and R2 are located are the voltage input ends of the voltage detection circuit, and the output end of the operational amplifier Y is the output end of the voltage detection circuit.

It should be noted that for descriptions of the same steps and content in this embodiment as in other embodiments, reference may be made to the descriptions in other embodiments, and will not be described again here.

In the embodiment of the present application, after determining the first target power line, the second target power line and the third target power line in the three-phase power supply device, the first target voltage between the first target power line and the second target power line, and the second target voltage between the first target power line and the third target power line are detected, and the fault detection result based on the first target voltage and the second target voltage is determined. In response to that the fault detection result indicates that the wiring error occurs in the three-phase power supply device, the first prompt information is generated. In this way, by analyzing the first target voltage between the first target power line and the second target power line, and the second target voltage between the first target power line and the third target power line, it can be determined that whether the wiring error occurs in the three-phase power supply device. Therefore, the present application solves the problem of the poor working efficiency caused by the wiring errors of the current three-phase four-wire power supply device, and realizes the method of effectively detecting wiring errors in advance, thereby effectively ensuring the working efficiency of three-phase four-wire power supply device and improving the intelligence of three-phase four-wire power supply device.

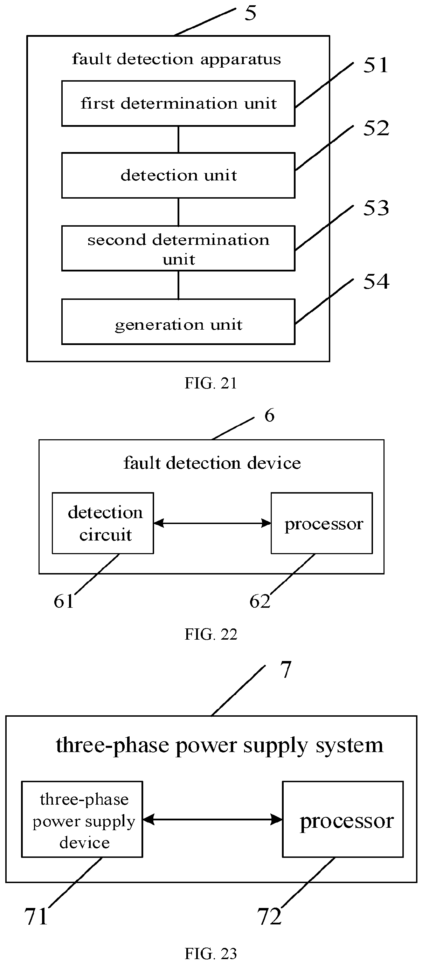

Based on the foregoing embodiments, the embodiments of the present application provide a fault detection apparatus. As shown in FIG. 21, the fault detection apparatus 5 may include: a first determination unit 51, a detection unit 52, a second determination unit 53 and a generation unit 54.

The first determination unit 51 is configured to determine a first target power line, a second target power line and a third target power line in a three-phase power supply device; the three-phase power supply device is configured to power the user electrical device.

The detection unit 52 is configured to detect a first target voltage between the first target power line and the second target power line, and a second target voltage between the first target power line and the third target power line.

The second determination unit 53 is configured to determine a fault detection result based on the first target voltage and the second target voltage; the fault detection result is configured to indicate whether a wiring error occurs in the three-phase power supply device.

The generation unit 54 is configured to generate first prompt information in response to the fault detection result indicating that the wiring error occurs in the three-phase power supply device; the first prompt information is configured to indicate that the wiring error occurs in the three-phase power supply device.

In other embodiments of the present application, the second determination unit includes: a first determination module and a second determination module.

The first determination module is configured to determine a third target voltage between the second target power line and the third target power line based on the first target voltage and the second target voltage; the first target voltage and the second target voltage are both the line voltages or phase voltages.

The second determination module is configured to determine the fault detection result based on the first target voltage, the second target voltage and the third target voltage.

In other embodiments of the present application, the first determination module may be configured to implement the following steps:

determining a target sum value of the first target voltage and the second target voltage; and
determining a negative value of the target sum to obtain the third target voltage.

In other embodiments of the present application, the second determination module may be configured to implement the following steps:

determining a first voltage effective value corresponding to the first target voltage, a second voltage effective value corresponding to the second target voltage, and a third voltage effective value corresponding to the third target voltage;
determining a first maximum effective value and a first minimum effective value from the first voltage effective value, the second voltage effective value and the third voltage effective value; and
determining the fault detection result based on the first maximum effective value and the first minimum effective value.

In other embodiments of the present application, the second determination module is configured to implement the step of determining the fault detection result based on the first maximum effective value and the first minimum effective value, which can be implemented through the following steps:

determining a first ratio of the first maximum effective value to the first minimum effective value;
in response to the first ratio being greater than or equal to a first threshold, determining the fault detection result to be the wiring error occurring in the three-phase power supply device; the first threshold is greater than 1 and less than or equal to $\sqrt{3}$ .

In other embodiments of the present application, both the first target voltage and the second target voltage are line voltages, and after performing the step of determining the fault detection result based on the first target voltage and the second target voltage, the second determination unit is further configured to implement the step of in response to that the fault detection result indicates that there is a wiring error in the three-phase power supply device, determine that a first target live wire except the two-phase live wire corresponding to the first maximum effective value is incorrectly connected to the neutral wire in the three-phase power supply device. The first preset threshold range is from $\sqrt{3}$ to $\sqrt{7}$, the first preset threshold range does not include $\sqrt{3}$, the first preset threshold range includes $\sqrt{7}$.

The generation unit is further configured to generate second prompt information configured to indicate that the first target live wire and the neutral wire are incorrectly connected.

In other embodiments of the present application, both the first target voltage and the second target voltage are phase voltages, and after performing the step of determining the fault detection result based on the first target voltage and the second target voltage, the second determination unit is further configured to implement the step of in response to the fault detection result indicating that the wiring error occurs in the three-phase power supply device, and the first ratio being within the first preset threshold range, determining that the second target live wire corresponding to the first minimum effective value and the neutral wire in the three-phase power supply device are incorrectly connected.

The generation unit is further configured to generate third prompt information configured to indicate that the second target live wire and the neutral wire are incorrectly connected.

The second determination unit is further configured to implement the step of in response to that the fault detection result indicating that the wiring error occurs in the three-phase power supply device, and the first ratio being within the second preset threshold range, determining that the third target live wire corresponding to the first maximum effective value and the neutral wire in the phase power supply device are incorrectly connected; the second preset threshold range is from 1 to $\sqrt{3}$, the second preset threshold range does not include 1, and the second preset threshold range includes $\sqrt{3}$.

The generation unit is further configured to generate fourth prompt information configured to indicate that the third target live wire and the neutral wire are incorrectly connected.

In other embodiments of the present application, the fault detection apparatus further includes an acquisition unit, a third determination unit and a display unit after the second determination unit.

The acquisition unit is configured to obtain the first output line current and the second output line current of the three-phase power supply device in response to that the fault detection result indicates that the line voltage is unbalanced.

The third determination unit is configured to determine the fault type based on the first output line current and the second output line current.

The display unit is configured to display fault prompt information indicating the fault type.

In other embodiments of the present application, when the first target voltage and the second target voltage are both line voltages, the second determination unit includes: a third determination module and a fourth determination module.

The third determination module is configured to determine the maximum line voltage and the minimum line voltage from the first target voltage, the second target voltage and the third target voltage.

The third determination module is further configured to determine the ratio of the maximum line voltage to the minimum line voltage.

The fourth determination module is configured to determine that the fault detection result is an unbalanced line voltage in response to that the ratio is greater than or equal to the preset threshold.

In other embodiments of the present application, the third determination unit includes: a fifth determination module and a sixth determination module.

The fifth determination module is configured to determine the third output line current based on the first output line current and the second output line current.

The sixth determination module is configured to determine the fault type based on the first output line current, the second output line current and the third output line current.

In other embodiments of the present application, the sixth determination module is specifically configured to implement the following steps:

in response to a slave relay connected to a power factor correction apparatus in the three-phase power supply device being conducted, determining a minimum line current from the first output line current, the second output line current and the third output line current; the slave relay is connected in series between a main circuit and a main alternating current power supply; and

in response to the minimum line current being less than or equal to a first preset current threshold, determining the fault type to be a phase loss fault.

In other embodiments of the present application, after performing the step of in response to the minimum line current being less than or equal to a first preset current threshold, determining the fault type to be a phase loss fault, the sixth determination module is further configured to perform the following steps:

determining the first target live wire corresponding to the minimum line current;
generating fifth prompt information configured to indicate the first target live wire phase loss; and
displaying the fifth prompt information.

In other embodiments of the present application, the sixth determination module is further configured to perform the following steps:

in response to the minimum line current being greater than the first preset current threshold, determining the fault type to be a wiring error type.

In other embodiments of the present application, the sixth determination module is further configured to perform the following steps:

in response to determining that the second target live wire and the neutral wire are incorrectly connected based on the first target voltage, the second target voltage and the third target voltage, generating sixth prompt information configured to indicate that the second target live wire and the neutral wire are incorrectly connected; and
displaying the sixth prompt information.

In other embodiments of the present application,

the fifth determination module is further configured to implement the step of in response to a main relay in the three-phase power supply device being conducted, determine the minimum line current from the first output line current, the second output line current and the third output line current;
the sixth determination module is further configured to implement the step of in response to the minimum line current being less than or equal to the second preset current threshold, and all current among the first output line current, the second output line current and the third output line current except the minimum line current being greater than or equal to the third preset current threshold, determine the fault type to be the phase loss fault. The third preset current threshold being greater than the second preset current threshold.

In other embodiments of the present application, after performing the step of in response to the minimum line current being less than or equal to the second preset current threshold, and all current among the first output line current, the second output line current and the third output line current except the minimum line current being greater than or equal to the third preset current threshold, determine the fault type to be the phase loss fault, the sixth determination module is further configured to perform the following steps:

determining the second target live wire corresponding to the minimum line current;
generating seventh prompt information configured to indicate the second target live wire phase loss; and
displaying the seventh prompt information.

In other embodiments of the present application, after performing the step of in response to the minimum line current being less than or equal to the second preset current threshold, and all current among the first output line current, the second output line current and the third output line current except the minimum line current being greater than or equal to the third preset current threshold, determine the fault type to be the phase loss fault, the sixth determination module is further configured to perform the following steps:
in response to detecting that at least one of the first output line current, the second output line current and the third output line current is greater than or equal to a fourth preset current threshold, controlling a main relay of the three-phase power supply device to be in an off state and a load of the three-phase power supply device to be in a shutdown state. The fourth preset current threshold is greater than the third preset current threshold.

In other embodiments of the present application, the first target power line and the second target power line are the live wires in the three-phase power supply device, and the third target power line is the neutral wire in the phase power supply device, and the second determination unit includes: a determination module and a second determination module.

The first determination module is further configured to determine the fourth target voltage between the second target power line and the third target power line based on the first target voltage and the second target voltage, and a fifth target voltage between the fourth target power line and the third target power line in the three-phase power supply device.

The second determination module is further configured to determine the fault detection result based on the second target voltage, the fourth target voltage and the fifth target voltage.

In other embodiments of the present application, in response to the first determination module implementing the step of determining the fourth target voltage between the second target power line and the third target power line based on the first target voltage and the second target voltage, and a fifth target voltage between the fourth target power line and the third target power line in the three-phase power supply device, it can be achieved by the following steps:

determining a difference between the second target voltage and the first target voltage to obtain the fourth target voltage;
determining a target product of the second target voltage and 2; and
determining a difference between the first target voltage and the target product to obtain the fifth target voltage.

In other embodiments of the present application, in response to the second determination module implementing the step of determining the fault detection result based on the second target voltage, the fourth target voltage and the fifth target voltage, it can be achieved by the following steps:

determining a second voltage effective value corresponding to the second target voltage, a fourth voltage effective value corresponding to the fourth target voltage, and a fifth voltage effective value corresponding to the fifth target voltage;
determining a second maximum effective value and a second minimum effective value from the second voltage effective value, the fourth voltage effective value and the fifth voltage effective value; and
determining the fault detection result based on the second maximum effective value and the second minimum effective value.

In other embodiments of the present application, in response to the second determination module implementing the step of determining the fault detection result based on the second maximum effective value and the second minimum effective value, it can be achieved by the following steps:

determining a second ratio of the second maximum effective value to the second minimum effective value; and
in response to the second ratio being greater than or equal to the second threshold, determining the fault detection result to be the wiring error occurring in the three-phase power supply device; the second threshold is greater than 1 and less than or equal to $\sqrt{3}$ .

In other embodiments of the present application, after implementing the step of determining the fault detection result based on the first target voltage and the second target voltage, the second determination unit is further configured to implement the step of in response to the fault detection result indicating that the wiring error occurs in the three-phase power supply device, and the second ratio being within the third preset threshold range, determining that the fourth target live wire corresponding to the second minimum effective value and the neutral wire in the three-phase power supply device are incorrectly connected; the third preset threshold range is from $\sqrt{3}$ to $\sqrt{7}$ , the third preset threshold range does not include $\sqrt{3}$ , and the third preset threshold range includes $\sqrt{7}$ .

The generation unit is further configured to generate the eighth prompt information configured to indicate that the fourth target live wire and the neutral wire are incorrectly connected.

The second determination unit is further configured to implement the step of in response to the fault detection result indicating that the wiring error occurs in the three-phase power supply device, and the second ratio being within the fourth preset threshold range, determining the fifth target live wire corresponding to the second maximum effective value and the neutral wire in the three-phase power supply device are incorrectly connected; the fourth preset threshold range is from 1 to $\sqrt{3}$ , the fourth preset threshold does not include 1, and the fourth preset threshold includes $\sqrt{3}$ .

The generation unit is further configured to generate ninth prompt information configured to indicate that the fifth target live wire and the neutral wire are incorrectly connected.

The fault detection apparatus is the same apparatus as the aforementioned voltage detection apparatus.

It should be noted that the specific implementation process of information interaction between units and modules in this embodiment can be referred to the implementation process in the fault detection method provided by the corresponding embodiments in FIGS. 1 to 4, FIG. 12 and FIGS. 16 to 17, will not be described again here.

In the embodiment of the present application, after determining the first target power line, the second target power line and the third target power line in the three-phase power supply device, the first target voltage between the first target power line and the second target power line, and the second target voltage between the first target power line and the third target power line are detected, and the fault detection result based on the first target voltage and the second target voltage is determined. In response to that the fault detection result indicates that the wiring error occurs in the three-phase power supply device, the first prompt information is generated. In this way, by analyzing the first target voltage between the first target power line and the second target power line, and the second target voltage between the first target power line and the third target power line, it can be determined that whether the wiring error occurs in the three-phase power supply device. Therefore, the present application solves the problem of the poor working efficiency caused by the wiring errors of the current three-phase four-wire power supply device, and realizes the method of effectively detecting wiring errors in advance, thereby effectively ensuring the working efficiency of three-phase four-wire power supply device and improving the intelligence of three-phase four-wire power supply device.

Based on the foregoing embodiments, the embodiments of the present application provide a fault detection device. As shown in FIG. 22, the fault detection device 6 may include: a detection circuit 61 and a processor 62.

The detection circuit 61 is configured to be connected to a first target power line, a second target power line and a third target power line in a three-phase power supply device to detect a first target voltage between the first target power line and the second target power line, and a second target voltage between the first target power line and the third target power line, and sending the first target voltage and the second target voltage to the processor; the three-phase power supply device is configured to supply power to user electrical device.

The processor 62 is configured to receive the first target voltage and the second target voltage sent by the detection circuit, and determine a fault detection result based on the first target voltage and the second target voltage; the fault detection result is configured to indicate whether a wiring error occurs in the three-phase power supply device; in response to the fault detection result indicating that the wiring error occurs in the three-phase power supply device, first prompt information is generated; and the first prompt information is configured to indicate that the wiring error occurs in the three-phase power supply device.

In other embodiments of the present application, the specific implementation process of the processor 62 may refer to the implementation processes of the methods shown in FIGS. 1 to 4, FIG. 12, and FIGS. 16 to 17, which will not be described in detail here. It should be noted that the detection circuit is the aforementioned voltage detection circuit.

Based on the foregoing embodiments, the embodiments of the present application provide a three-phase power supply system. As shown in FIG. 23, the three-phase power supply system 7 may include: a three-phase power supply device 71 for providing three-phase power and a fault detection device 72 for implementing the fault detection methods of FIGS. 1 to 4, 12 and 16 to 17. The specific implementation process of the fault detection device 72 can refer to the methods shown in FIGS. 1 to 4, FIG. 12 and FIGS. 16 to 17. The implementation process will not be described in detail here. In addition, the three-phase power supply device 71 here is the same device as the aforementioned three-phase power supply device E.

Based on the foregoing embodiments, the embodiments of the present application provide a computer-readable storage medium, which is referred to as a storage medium. The computer-readable storage medium stores one or more programs, and the one or more programs can be executed by one or more processors to implement the fault detection method provided by the embodiments corresponding to FIGS. 1 to 4, FIG. 12 and FIGS. 16 to 17, which will not be described again here.

The above are only some embodiments of the present application, and are not intended to limit the scope of the present application. Any modifications, equivalent substitutions and improvements made within the spirit and scope of the present application, are included in the scope of present application.

**Claims**

1. A fault detection method, **characterized by** comprising: determining a first target power line, a second target power line and a third target power line in a three-phase power supply device; wherein the three-phase power supply device is configured to power a user electrical device; detecting a first target voltage between the first target power line and the second target power line, and a second target voltage between the first target power line and the third target power line; determining a fault detection result based on the first target voltage and the second target voltage; wherein the fault detection result is configured to indicate whether a wiring error occurs in the three-phase power supply device; and in response to the fault detection result indicating that the wiring error occurs in the three-phase power supply device, generating first prompt information; wherein the first prompt information is configured to indicate the wiring error in the three-phase power supply device.

2. The method according to claim 1, wherein the determining the fault detection result based on the first target voltage and the second target voltage comprises: determining a third target voltage between the second target power line and the third target power line based on the first target voltage and the second target voltage; wherein the first target voltage and the second target voltage are all line voltages or phase voltages; and determining the fault detection result based on the first target voltage, the second target voltage and the third target voltage.

3. The method according to claim 2, wherein the determining the third target voltage between the second target power line and the third target power line based on the first target voltage and the second target voltage comprises: determining a target sum value of the first target voltage and the second target voltage; and determining a negative value of the target sum to obtain the third target voltage.

4. The method according to claim 2 or 3, wherein the determining the fault detection result based on the first target voltage, the second target voltage and the third target voltage comprises: determining a first voltage effective value corresponding to the first target voltage, a second voltage effective value corresponding to the second target voltage, and a third voltage effective value corresponding to the third target voltage; determining a first maximum effective value and a first minimum effective value from the first voltage effective value, the second voltage effective value and the third voltage effective value; and determining the fault detection result based on the first maximum effective value and the first minimum effective value.

5. The method according to claim 4, wherein the determining the fault detection result based on the first maximum effective value and the first minimum effective value comprises: determining a first ratio of the first maximum effective value to the first minimum effective value; and in response to the first ratio being greater than or equal to a first threshold, determining the fault detection result to be the wiring error occurring in the three-phase power supply device; wherein the first threshold is greater than 1 and less than or equal to $\sqrt{3}$.

6. The method according to claim 5, wherein the first target voltage and the second target voltage are both line voltages, and after the determining the fault detection result based on the first target voltage and the second target voltage, the method further comprises: in response to the fault detection result indicating that the wiring error occurs in the three-phase power supply device, determining that a first target live wire except the two-phase live wire corresponding to the first maximum effective value is incorrectly connected to the neutral wire in the three-phase power supply device; and generating second prompt information configured to indicate that the first target live wire and the neutral wire are incorrectly connected.

7. The method according to claim 5, wherein the first target voltage and the second target voltage are both phase voltages, and after the determining the fault detection result based on the first target voltage and the second target voltage, the method further comprises: in response to the fault detection result indicating that the wiring error occurs in the three-phase power supply device, and the first ratio being within the first preset threshold range, determining that the second target live wire corresponding to the first minimum effective value and the neutral wire in the three-phase power supply device are incorrectly connected; wherein the first preset threshold range is from $\sqrt{3}$ to $\sqrt{7}$, the first preset threshold range does not comprise $\sqrt{3}$, the first preset threshold range comprise $\sqrt{7}$; generating third prompt information configured to indicate that the second target live wire and the neutral wire are incorrectly connected; in response to that the fault detection result indicating that the wiring error occurs in the three-phase power supply device, and the first ratio being within the second preset threshold range, determining that the third target live wire corresponding to the first maximum effective value and the neutral wire in the phase power supply device are incorrectly connected; wherein, the second preset threshold range is from 1 to $\sqrt{3}$, the second preset threshold range does not comprise 1, and the second preset threshold range comprises $\sqrt{3}$; and generating fourth prompt information configured to indicate that the third target live wire and the neutral wire are incorrectly connected.

8. The method according to claim 2, wherein after the determining the fault detection result based on the first target voltage and the second target voltage, the method further comprises: in response to the fault detection result indicating that a line voltage is unbalanced, obtaining a first output line current and a second output line current of the three-phase power supply device; determining a fault type based on the first output line current and the second output line current; and displaying fault prompt information configured to indicate the fault type.

9. The method according to claim 8, wherein the first target voltage and the second target voltage are both line voltages, and the determining the fault detection result based on the first target voltage, the second target voltage and the third target voltage comprises: determining a maximum line voltage and a minimum line voltage from the first target voltage, the second target voltage, and the third target voltage; determining a ratio of the maximum line voltage to the minimum line voltage; and in response to the ratio being greater than or equal to a preset threshold, determining the fault detection result is that the line voltage is unbalanced.

10. The method according to claim 9, wherein the determining the fault type based on the first output line current and the second output line current comprises: determining a third output line current based on the first output line current and the second output line current; and determining the fault type based on the first output line current, the second output line current and the third output line current.

11. The method according to claim 10, wherein the determining the fault type based on the first output line current, the second output line current and the third output line current comprises: in response to a slave relay connected to a power factor correction apparatus in the three-phase power supply device being conducted, determining a minimum line current from the first output line current, the second output line current and the third output line current; wherein, the slave relay is connected in series between a main circuit and a main alternating current power supply; and in response to the minimum line current being less than or equal to a first preset current threshold, determining the fault type to be a phase loss fault.

12. The method according to claim 11, wherein after the in response to the minimum line current being less than a first preset current threshold, determining the fault type to be the phase loss fault, the method further comprises: determining the first target live wire corresponding to the minimum line current; generating fifth prompt information configured to indicate the first target live wire phase loss; and displaying the fifth prompt information.

13. The method according to claim 11, further comprising: in response to the minimum line current being greater than the first preset current threshold, determining the fault type to be a wiring error type.

14. The method according to claim 13, further comprising: in response to determining that the second target live wire and the neutral wire are incorrectly connected based on the first target voltage, the second target voltage and the third target voltage, generating sixth prompt information configured to indicate that the second target live wire and the neutral wire are incorrectly connected; and displaying the sixth prompt information.

15. The method according to claim 11, wherein the determining the fault type based on the first output line current, the second output line current and the third output line current comprises: in response to a main relay in the three-phase power supply device being conducted, determining the minimum line current from the first output line current, the second output line current and the third output line current; and in response to the minimum line current being less than or equal to the second preset current threshold, and all current among the first output line current, the second output line current and the third output line current except the minimum line current being greater than or equal to the third preset current threshold, determining the fault type to be the phase loss fault; wherein the third preset current threshold is greater than the second preset current threshold.

16. The method according to claim 15, wherein after the in response to the minimum line current being less than or equal to the second preset current threshold, and all current among the first output line current, the second output line current and the third output line current except the minimum line current being greater than or equal to the third preset current threshold, determining the fault type to be the phase loss fault, the method further comprises: determining the second target live wire corresponding to the minimum line current; generating seventh prompt information configured to indicate the second target live wire phase loss; and displaying the seventh prompt information.

17. The method according to claim 15, wherein after the in response to the minimum line current being less than or equal to the second preset current threshold, and all current among the first output line current, the second output line current and the third output line current except the minimum line current being greater than or equal to the third preset current threshold, determining the fault type to be the phase loss fault, the method further comprises: in response to detecting that at least one of the first output line current, the second output line current and the third output line current is greater than or equal to a fourth preset current threshold, controlling a main relay of the three-phase power supply device to be in an off state and a load of the three-phase power supply device to be in a shutdown state; wherein the fourth preset current threshold is greater than the third preset current threshold.

18. The method according to claim 1, wherein the first target power line and the second target power line are the live wires in the three-phase power supply device, and the third target power line is the neutral wire in the phase power supply device, and the determining the fault detection result based on the first target voltage and the second target voltage comprises: determining a fourth target voltage between the second target power line and the third target power line and a fifth target voltage between a fourth target power line and the third target power line in the three-phase power supply device based on the first target voltage and the second target voltage; and determining the fault detection result based on the second target voltage, the fourth target voltage and the fifth target voltage.

19. The method according to claim 18, wherein the determining a fourth target voltage between the second target power line and the third target power line and a fifth target voltage between a fourth target power line and the third target power line in the three-phase power supply device based on the first target voltage and the second target voltage comprises: determining a difference between the second target voltage and the first target voltage to obtain the fourth target voltage; determining a target product of the second target voltage and 2; and determining a difference between the first target voltage and the target product to obtain the fifth target voltage.

20. The method according to claim 18 or 19, wherein the determining the fault detection result based on the second target voltage, the fourth target voltage and the fifth target voltage comprises: determining a second voltage effective value corresponding to the second target voltage, a fourth voltage effective value corresponding to the fourth target voltage, and a fifth voltage effective value corresponding to the fifth target voltage; determining a second maximum effective value and a second minimum effective value from the second voltage effective value, the fourth voltage effective value and the fifth voltage effective value; and determining the fault detection result based on the second maximum effective value and the second minimum effective value.

21. The method according to claim 20, wherein the determining the fault detection result based on the second maximum effective value and the second minimum effective value comprises: determining a second ratio of the second maximum effective value to the second minimum effective value; and in response to the second ratio being greater than or equal to the second threshold, determining the fault detection result to be the wiring error occurring in the three-phase power supply device; wherein the second threshold is greater than 1 and less than or equal to $\sqrt{3}$.

22. The method according to claim 21, wherein after the determining the fault detection result based on the first target voltage and the second target voltage, the method further comprises: in response to the fault detection result indicating that the wiring error occurs in the three-phase power supply device, and the second ratio being within the third preset threshold range, determining that the fourth target live wire corresponding to the second minimum effective value and the neutral wire in the three-phase power supply device are incorrectly connected; wherein, the third preset threshold range is from $\sqrt{3}$ to $\sqrt{7}$, the third preset threshold range does not comprise $\sqrt{3}$, and the third preset threshold range comprises $\sqrt{7}$; generating eighth prompt information configured to indicate that the fourth target live wire and the neutral wire are incorrectly connected; in response to the fault detection result indicating that the wiring error occurs in the three-phase power supply device, and the second ratio being within the fourth preset threshold range, determining the fifth target live wire corresponding to the second maximum effective value and the neutral wire in the three-phase power supply device are incorrectly connected; wherein, the fourth preset threshold range is from 1 to $\sqrt{3}$, the fourth preset threshold does not comprise 1, and the fourth preset threshold comprises $\sqrt{3}$; and generating ninth prompt information configured to indicate that the fifth target live wire and the neutral wire are incorrectly connected.

23. A fault detection apparatus, **characterized by** comprising: a first determination unit; a detection unit; a second determination unit; and a generation unit; wherein: the first determination unit is configured to determine a first target power line, a second target power line and a third target power line in a three-phase power supply device; wherein the three-phase power supply device is configured to power a user electrical device; the detection unit is configured to detect a first target voltage between the first target power line and the second target power line, and a second target voltage between the first target power line and the third target power line; the second determination unit is configured to determine a fault detection result based on the first target voltage and the second target voltage; wherein the fault detection result is configured to indicate whether a wiring error occurs in the three-phase power supply device; and the generation unit is configured to generate first prompt information in response to the fault detection result indicating that the wiring error occurs in the three-phase power supply device; wherein the first prompt information is configured to indicate that the wiring error occurs in the three-phase power supply device.

24. A fault detection device, **characterized by** comprising: a detection circuit and a processor; wherein: the detection circuit is configured to be connected to a first target power line, a second target power line and a third target power line in a three-phase power supply device to detect a first target voltage between the first target power line and the second target power line, and a second target voltage between the first target power line and the third target power line, and sending the first target voltage and the second target voltage to the processor; wherein, the three-phase power supply device is configured to supply power to user electrical device; the processor is configured to receive the first target voltage and the second target voltage sent by the detection circuit, and determine a fault detection result based on the first target voltage and the second target voltage; wherein, the fault detection result is configured to indicate whether a wiring error occurs in the three-phase power supply device; in response to the fault detection result indicating that the wiring error occurs in the three-phase power supply device, first prompt information is generated; and wherein, the first prompt information is configured to indicate that the wiring error occurs in the three-phase power supply device.

25. A three-phase power supply system, **characterized by** comprising: a three-phase power supply device configured to provide three-phase power and the fault detection device according to claim 24.

26. A storage medium, **characterized in that**, a fault detection program is stored on the storage medium, and when the fault detection program is executed by a processor, steps of the fault detection method according to any one of claims 1 to 22 are implemented.

determining a first target power line, a second target power line and a third target power line in a three-phase power supply device — 101

detecting a first target voltage between the first target power line and the second target power line, and a second target voltage between the first target power line and the third target power line — 102

determining a fault detection result based on the first target voltage and the second target voltage — 103

in response to the fault detection result indicating that the wiring error occurs in the three-phase power supply device, generating first prompt information — 104

FIG. 1

determining a first target power line, a second target power line and a third target power line in a three-phase power supply device ⎡⎯ 201

↓

detecting a first target voltage between the first target power line and the second target power line, and a second target voltage between the first target power line and the third target power line ⎡⎯ 202

↓

determining a third target voltage between the second target power line and the third target power line based on the first target voltage and the second target voltage ⎡⎯ 203

↓

determining the fault detection result based on the first target voltage, the second target voltage and the third target voltage ⎡⎯ 204

↓

in response to the fault detection result indicating that the wiring error occurs in the three-phase power supply device, generating first prompt information ⎡⎯ 205

FIG. 2

determining a first target power line, a second target power line and a third target power line in a three-phase power supply device — 201

detecting a first target voltage between the first target power line and the second target power line, and a second target voltage between the first target power line and the third target power line — 202

determining a third target voltage between the second target power line and the third target power line based on the first target voltage and the second target voltage — 203

determining the fault detection result based on the first target voltage, the second target voltage and the third target voltage — 204

in response to the fault detection result indicating that the wiring error occurs in the three-phase power supply device, generating first prompt information — 205

in response to the fault detection result indicating that the wiring error occurs in the three-phase power supply device, determining that a first target live wire except the two-phase live wire corresponding to the first maximum effective value is incorrectly connected to the neutral wire in the three-phase power supply device — 206

generating second prompt information configured to indicate that the first target live wire and the neutral wire are incorrectly connected — 207

FIG. 3

determining a first target power line, a second target power line and a third target power line in a three-phase power supply device ⌐— 201

↓

detecting a first target voltage between the first target power line and the second target power line, and a second target voltage between the first target power line and the third target power line ⌐— 202

↓

determining a third target voltage between the second target power line and the third target power line based on the first target voltage and the second target voltage ⌐— 203

↓

determining the fault detection result based on the first target voltage, the second target voltage and the third target voltage ⌐— 204

↓

in response to the fault detection result indicating that the wiring error occurs in the three-phase power supply device, generating first prompt information ⌐— 205

↓

in response to the fault detection result indicating that the wiring error occurs in the three-phase power supply device, determining that a first target live wire except the two-phase live wire corresponding to the first maximum effective value is incorrectly connected to the neutral wire in the three-phase power supply device ⌐— 208

↓

generating second prompt information configured to indicate that the first target live wire and the neutral wire are incorrectly connected ⌐— 209

↓

in response to that the fault detection result indicating that the wiring error occurs in the three-phase power supply device, and the first ratio being within the second preset threshold range, determining that the third target live wire corresponding to the first maximum effective value and the neutral wire in the phase power supply device are incorrectly connected ⌐— 210

↓

generating fourth prompt information configured to indicate that the third target live wire and the neutral wire are incorrectly connected ⌐— 211

FIG. 4

main alternating current

D1  D3  D5

inverter compressor

+ C1

IPM1

M

+ C2

A  L1
B  L2
C  L3
N

D2  D4  D6

direct current fan

auxiliary power supply

IPM2

M

FIG. 5a

main alternating current

Q1  Q3  Q5

inverter compressor

+ C1

IPM1

M

A  L1
B  L2
C  L3
N

+ C2

Q2  Q4  Q6

direct current fan

auxiliary power supply

IPM2

M

FIG. 5b

main alternating
current

D1    D3    D5

T1    T2
T3    T4
T5    T6

+  C1

IPM1

inverter
compressor

M

D2    D4    D6

+  C2

direct current fan

auxiliary
power
supply

IPM2

M

FIG. 5c

E1    E    G

A    L1
B    L2
C    L3
N

user power supply
device

voltage
detection
circuit

processor    F

FIG. 6

E1

E

G

A
B
C
N

L1
L2
L3

user power supply
device

F

voltage
detection
circuit

processor

FIG. 7

E

G

A
B
C
N

L 1
L 2
L 3

user power supply
device

F

voltage
detection
circuit

voltage
detection
circuit

processor

FIG. 8a

FIG. 8b

FIG. 9

FIG. 10a

FIG. 10b

$V_{BC}$

$V_{AC}$

FIG. 10c

E

G

A L1

B L2

C L3

N

user electrical
device

voltage
detection
circuit

voltage
detection
circuit

voltage
detection
circuit

processor

F

FIG. 11a

FIG. 11b

determining a first target power line, a second target power line and a third target power line in a three-phase power supply device ⌐ 301

detecting a first target voltage between the first target power line and the second target power line, and a second target voltage between the first target power line and the third target power line ⌐ 302

determining a third target voltage between the second target power line and the third target power line based on the first target voltage and the second target voltage ⌐ 303

determining the fault detection result based on the first target voltage, the second target voltage and the third target voltage ⌐ 304

in response to the fault detection result indicating that a line voltage is unbalanced, obtaining a first output line current and a second output line current of the three-phase power supply device ⌐ 305

determining a fault type based on the first output line current and the second output line current ⌐ 306

displaying fault prompt information configured to indicate the fault type ⌐ 307

FIG. 12

FIG. 13

FIG. 14

14/19

FIG. 15a

FIG. 15b

determining a first target power line, a second target power line and a third target power line in a three-phase power supply device 〜 401

detecting a first target voltage between the first target power line and the second target power line, and a second target voltage between the first target power line and the third target power line 〜 402

determining a fourth target voltage between the second target power line and the third target power line and a fifth target voltage between a fourth target power line and the third target power line in the three-phase power supply device based on the first target voltage and the second target voltage 〜 403

determining the fault detection result based on the second target voltage, the fourth target voltage and the fifth target voltage 〜 404

in response to the fault detection result indicating that the wiring error occurs in the three-phase power supply device, generating first prompt information 〜 405

FIG. 16

determining a first target power line, a second target power line and a third target power line in a three-phase power supply device — 401

detecting a first target voltage between the first target power line and the second target power line, and a second target voltage between the first target power line and the third target power line — 402

determining a fourth target voltage between the second target power line and the third target power line and a fifth target voltage between a fourth target power line and the third target power line in the three-phase power supply device based on the first target voltage and the second target voltage — 403

determining the fault detection result based on the second target voltage, the fourth target voltage and the fifth target voltage — 404

in response to the fault detection result indicating that the wiring error occurs in the three-phase power supply device, generating first prompt information — 405

in response to the fault detection result indicating that the wiring error occurs in the three-phase power supply device, and the second ratio being within the third preset threshold range, determining that the fourth target live wire corresponding to the second minimum effective value and the neutral wire in the three-phase power supply device are incorrectly connected — 406

generating eighth prompt information configured to indicate that the fourth target live wire and the neutral wire are incorrectly connected — 407

in response to the fault detection result indicating that the wiring error occurs in the three-phase power supply device, and the second ratio being within the fourth preset threshold range, determining the fifth target live wire corresponding to the second maximum effective value and the neutral wire in the three-phase power supply device are incorrectly connected; the fourth preset threshold range is from 1 to √3, the fourth preset threshold does not include 1, and the fourth preset threshold includes √3 — 408

generating ninth prompt information configured to indicate that the fifth target live wire and the neutral wire are incorrectly connected — 409

FIG. 17

E

G

A    L1

B    L2

C    L3

N

user electrical
device

voltage
detection
circuit

voltage
detection
circuit

processor

F

FIG. 18

$V_{NB}$

$V_{AN}$    $V_{AN}$

FIG. 19a

$V_{BA}$

$V_{BA}$

$V_{AN}$

FIG. 19b

$V_{AB}$

$V_{CA}$

$V_{CA}$

FIG. 19c

R3 DC

GND

R1

R2

Y

R4

FIG. 20

5

## fault detection apparatus

| first determination unit | 51 |

| detection unit | 52 |

| second determination unit | 53 |

| generation unit | 54 |

FIG. 21

6

## fault detection device

| detection circuit | | processor |

61                              62

FIG. 22

7

## three-phase power supply system

| three-phase power supply device | | processor |

71                              72

FIG. 23

## INTERNATIONAL SEARCH REPORT

| International application No. |
|---|
| **PCT/CN2022/092193** |

**A. CLASSIFICATION OF SUBJECT MATTER**

G01R 31/42(2006.01)i;  G01R 31/55(2020.01)i;  G01R 29/16(2006.01)i

According to International Patent Classification (IPC) or to both national classification and IPC

**B. FIELDS SEARCHED**

Minimum documentation searched (classification system followed by classification symbols)

G01R31/-,  G01R29/-

Documentation searched other than minimum documentation to the extent that such documents are included in the fields searched

Electronic data base consulted during the international search (name of data base and, where practicable, search terms used)

WPI, EPODOC, CNPAT, CNTXT, CNKI, WOTXT, USTXT, EPTXT, JPTXT: 佛山市顺德区美的电子科技有限公司, 广东美的制冷设备有限公司, 美的集团股份有限公司, 黄招彬, 张杰楠, 黄正辉, 龙谭, 韦东, 徐锦清, 文先仕, 赵鸣, 相电压, 线电压, 有效值, 比值, 接线, 接错, 接反, 零线, 空调, ratio, specific value, line voltage, voltage, current, effective value, phase, three-phase, power, power factor correction

**C. DOCUMENTS CONSIDERED TO BE RELEVANT**

| Category* | Citation of document, with indication, where appropriate, of the relevant passages | Relevant to claim No. |
|---|---|---|
| X | CN 107247242 A (TCL AIR CONDITIONER (ZHONGSHAN) CO., LTD. et al.) 13 October 2017 (2017-10-13) <br> description, paragraphs [0032]-[0045] | 1-3, 18, 19, 23-26 |
| Y | CN 107247242 A (TCL AIR CONDITIONER (ZHONGSHAN) CO., LTD. et al.) 13 October 2017 (2017-10-13) <br> description, paragraphs [0032]-[0045] | 4-10, 20-22 |
| Y | CN 112540295 A (ZHUHAI GREE ELECTRIC APPLIANCES INC.) 23 March 2021 (2021-03-23) <br> description, paragraphs [0068]-[0071] | 4-10, 20-22 |
| PX | CN 113687151 A (HEFEI MIDEA HEATING & VENTILATING EQUIPMENT CO., LTD. et al.) 23 November 2021 (2021-11-23) <br> description, paragraphs [0073]-[0078] and [0118]-[0124] | 1-7, 18-26 |
| A | CN 112054492 A (CSG DIGITAL POWER GRID RESEARCH INSTITUTE CO., LTD. et al.) 08 December 2020 (2020-12-08) <br> entire document | 1-26 |

☑ Further documents are listed in the continuation of Box C.　☑ See patent family annex.

| | |
|---|---|
| * Special categories of cited documents: <br> "A" document defining the general state of the art which is not considered to be of particular relevance <br> "E" earlier application or patent but published on or after the international filing date <br> "L" document which may throw doubts on priority claim(s) or which is cited to establish the publication date of another citation or other special reason (as specified) <br> "O" document referring to an oral disclosure, use, exhibition or other means <br> "P" document published prior to the international filing date but later than the priority date claimed | "T" later document published after the international filing date or priority date and not in conflict with the application but cited to understand the principle or theory underlying the invention <br> "X" document of particular relevance; the claimed invention cannot be considered novel or cannot be considered to involve an inventive step when the document is taken alone <br> "Y" document of particular relevance; the claimed invention cannot be considered to involve an inventive step when the document is combined with one or more other such documents, such combination being obvious to a person skilled in the art <br> "&" document member of the same patent family |

| Date of the actual completion of the international search | Date of mailing of the international search report |
|---|---|
| **21 July 2022** | **11 August 2022** |

| Name and mailing address of the ISA/CN | Authorized officer |
|---|---|
| **China National Intellectual Property Administration (ISA/CN)** <br> **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

## INTERNATIONAL SEARCH REPORT

| | International application No. |
|---|---|
| | **PCT/CN2022/092193** |

**C.    DOCUMENTS CONSIDERED TO BE RELEVANT**

| Category* | Citation of document, with indication, where appropriate, of the relevant passages | Relevant to claim No. |
|---|---|---|
| A | CN 109633339 A (CHINA SHENHUA ENERGY CO., LTD. et al.) 16 April 2019 (2019-04-16) <br> entire document | 1-26 |
| A | WO 2019075671 A1 (CHINA ELECTRIC POWER RESEARCH INSTITUTE CO., LTD.) 25 April 2019 (2019-04-25) <br> entire document | 1-26 |
| A | JP 2019165569 A (MITSUBISHI ELECTRIC CORP.) 26 September 2019 (2019-09-26) <br> entire document | 1-26 |
| A | US 2002005721 A1 (ABB RESEARCH LTD.) 17 January 2002 (2002-01-17) <br> entire document | 1-26 |

Form PCT/ISA/210 (second sheet) (January 2015)

INTERNATIONAL SEARCH REPORT
Information on patent family members

International application No.

**PCT/CN2022/092193**

| Patent document cited in search report | | | Publication date (day/month/year) | Patent family member(s) | | | Publication date (day/month/year) |
|---|---|---|---|---|---|---|---|
| CN | 107247242 | A | 13 October 2017 | None | | | |
| CN | 112540295 | A | 23 March 2021 | None | | | |
| CN | 113687151 | A | 23 November 2021 | None | | | |
| CN | 112054492 | A | 08 December 2020 | None | | | |
| CN | 109633339 | A | 16 April 2019 | None | | | |
| WO | 2019075671 | A1 | 25 April 2019 | JP | 2019537701 | A | 26 December 2019 |
| JP | 2019165569 | A | 26 September 2019 | KR | 20190110411 | A | 30 September 2019 |
| US | 2002005721 | A1 | 17 January 2002 | EP | 0856739 | A1 | 05 August 1998 |
| | | | | DE | 69731180 | D1 | 18 November 2004 |
| | | | | IT | 1305598 | B1 | 09 May 2001 |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202110579638

- CN 202210332963